# EUROPEAN PATENT SPECIFICATION

(11) **EP 4 400 914 B1**
(45) Date of publication and mention of the grant of the patent: **17.12.2025**
(21) Application number: 24150350.7
(22) Date of filing: 04.01.2024
(51) Int. Cl.: G03F 7/09

(54) **COMPOSITION FOR FORMING RESIST UNDERLAYER FILM, PATTERNING PROCESS, AND METHOD FOR FORMING RESIST UNDERLAYER FILM**
ZUSAMMENSETZUNG ZUR BILDUNG EINES RESISTUNTERSCHICHTFILMS, STRUKTURIERUNGSVERFAHREN UND VERFAHREN ZUR BILDUNG EINES RESISTUNTERSCHICHTFILMS
COMPOSITION POUR FORMER UN FILM DE SOUS-COUCHE DE RÉSERVE, PROCÉDÉ DE FORMATION DE MOTIFS ET PROCÉDÉ DE FORMATION D'UN FILM DE SOUS-COUCHE DE RÉSERVE

(30) Priority: 10.01.2023 JP 2023001687
(43) Date of publication of application: 17.07.2024
(73) Proprietor: Shin-Etsu Chemical Co., Ltd., Tokyo 100-0005 (JP)
(72) Inventor: Kobayashi, Naoki, Niigata (JP); Ishiwata, Kenta, Niigata (JP); Kori, Daisuke, Niigata (JP)
(74) Representative: Sonnenhauser, Thomas Martin

(56) References cited:
- US-A1- 2003 073 040
- US-A1- 2004 034 155
- US-A1- 2007 122 740
- US-A1- 2014 316 079
- US-A1- 2014 323 668
- US-A1- 2015 322 219
- US-B2- 9 091 922

## Description

### TECHNICAL FIELD

The present invention relates to: a composition for forming a resist underlayer film that can be used for fine patterning by way of a multilayer resist method in a semiconductor device manufacturing process; a patterning process using the composition; and a method for forming a resist underlayer film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist underlayer film having a different etching selectivity from a photoresist film (i.e., a resist upper layer film) is placed between the resist upper layer film and a substrate to be processed; a pattern is formed in the resist upper layer film; the pattern is transferred to the resist underlayer film by dry etching while using the resist upper layer film pattern as a dry etching mask; and the pattern is further transferred to the substrate to be processed by dry etching while using the resist underlayer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type resist underlayer film composition excellent in filling and planarizing properties, for example, the composition disclosed in Patent Document 2 has been reported. However, in view of application of this composition in the advanced generation, there is a concern about dry etching resistance. The application limit of the previously-known coating-type resist underlayer film compositions is thus approaching.

To solve the above problems, Patent Document 3 reports that etching resistance at the time of substrate processing can be improved by heating a resist underlayer film in an atmosphere having an oxygen concentration of 1% by volume or less at a temperature exceeding 450°C and 800°C or lower. However, many of the resist underlayer films used in the Examples contain a resin or a compound containing hydroxy groups or propargyl groups. Therefore, the resist underlayer films are thought to be unfavorable from the viewpoint of etching resistance, since oxygen atoms remain in the films.

### CITATION LIST

### PATENT LITERATURE

Patent Document 1: JP2004-205685A
Patent Document 2: JP6714493B2
Patent Document 3: JP6711104B2

US 2015/322219 A1, US 2004/034155 A1, US 9 091 922 B2, US 2007/122740 A1 and US 2003/073040 A1 are documents that illustrate relevant concepts known in the field.

### SUMMARY OF INVENTION

### TECHNICAL PROBLEM

The present invention has been made in view of the above-described circumstances. An object of the present invention is to provide: a composition for forming a resist underlayer film that exhibits much better dry etching resistance than conventional resist underlayer film materials; a patterning process in which the composition is used as a resist underlayer film material; and a method for forming a resist underlayer film.

### SOLUTION TO PROBLEM

To achieve the object, the present invention provides a composition for forming a resist underlayer film, comprising: (A) a polymer having a structure represented by the following general formula (1A); (B) a crosslinking agent represented by the following general formula (B-1); and (C) an organic solvent, wherein the polymer (A) contains no hydroxy groups and the crosslinking agent (B) is contained in an amount of 5 to 50 parts by mass relative to 100 parts by mass of the polymer (A), 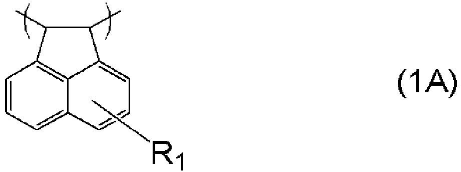
wherein R₁ represents a hydrogen atom, a halogen atom, or a linear, branched, or cyclic hydrocarbon group having 1 to 20 carbon atoms, 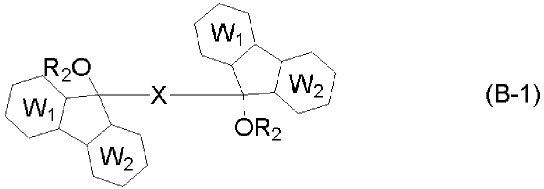
wherein W₁ and W₂ each independently represent a benzene ring or a naphthalene ring optionally having a substituent, each R₂ independently represents a hydrogen atom or a monovalent organic group having 1 to 20 carbon atoms, and X represents a group represented by one of the following formulae (2), 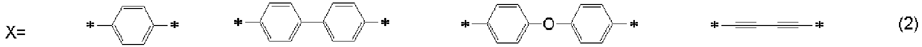
wherein "*" represents an attachment point.

Such a composition for forming a resist underlayer film includes a combination of a polymer having a structure represented by the general formula (1A) and a crosslinking agent represented by the general formula (B-1), and the composition contains no polymers containing a hydroxy group. Therefore, by thermosetting, the composition can form a high-carbon film having excellent etching resistance at the time of substrate processing.

The composition preferably further comprises a polymer having partial structures represented by the following general formulae (1B), 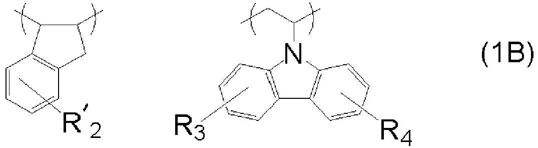 wherein R'₂, R₃, and R₄ each independently represent a hydrogen atom, a halogen atom, or a linear, branched, or cyclic hydrocarbon group having 1 to 20 carbon atoms.

When the composition further contains a polymer having partial structures represented by the general formulae (1B), thermal flowability is improved, and it is possible to provide a composition for forming a resist underlayer film excellent for filling and planarizing a stepped substrate.

The polymer (A) preferably has structures represented by the following general formulae (1C), 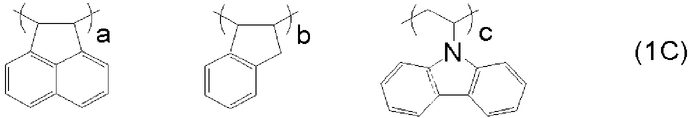 wherein "a", "b", and "c" satisfy a+b+c = 1, 0.5 ≤ a ≤ 0.9, and 0.1 ≤ b+c ≤ 0.5.

A composition for forming a resist underlayer film where the polymer (A) has structures represented by the general formulae (1C) can achieve high levels of both etching resistance during substrate processing and filling and planarizing properties regarding stepped substrates.

The polymer (A) preferably has a weight-average molecular weight Mw of 500 to 5,000 as measured by gel permeation chromatography in terms of polystyrene.

When the polymer (A) has the above-described weight-average molecular weight Mw, the composition for forming a resist underlayer film has excellent thermal flowability. Therefore, when the composition is contained in a resist underlayer film material, not only is it possible to fill favorably fine structures formed on a substrate, it is also possible to form a resist underlayer film that can achieve flatness in the entire substrate. It is also possible to provide a resist underlayer film that produces little sublimation product during baking.

The crosslinking agent (B) preferably satisfies 1.00 ≤ Mw/Mn ≤ 1.25, where Mw is a weight-average molecular weight and Mn is a number-average molecular weight measured by gel permeation chromatography in terms of polystyrene.

When the crosslinking agent (B) has the above-described molecular weight dispersity, the composition for forming a resist underlayer film has excellent thermal flowability. Therefore, when the composition is contained in a resist underlayer film material, not only is it possible to fill favorably fine structures formed on a substrate, it is also possible to form a resist underlayer film that can achieve flatness in the entire substrate.

The composition preferably comprises (D) a flowability accelerator having a weight reduction rate of less than 30% at 30°C to 190°C and a weight reduction rate of 98% or more at 30°C to 350°C.

The flowability accelerator (D) contributes to the enhancement of flowability when applying the composition, and since the flowability accelerator is eliminated from the film after baking at 350°C, filling and planarizing properties can be improved without dry etching resistance being degraded. In addition, the flowability accelerator can also suppress the generation of defects induced by dryness, and can also contribute to the improvement of yield in semiconductor production.

In this event, the flowability accelerator (D) preferably contains one or more compounds selected from the following general formulae (i) to (iii), 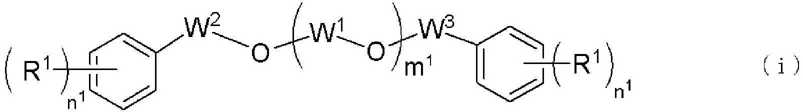
wherein each R¹ independently represents a hydrogen atom, a hydroxy group, or an optionally substituted organic group having 1 to 10 carbon atoms; W¹ represents a phenylene group, or a divalent group represented by the following general formula (i-1); W² and W³ each independently represent a single bond or a divalent group represented by one of the following formulae (i-2); "m¹" represents an integer of 1 to 10; and "n¹" represents an integer of 0 to 5, 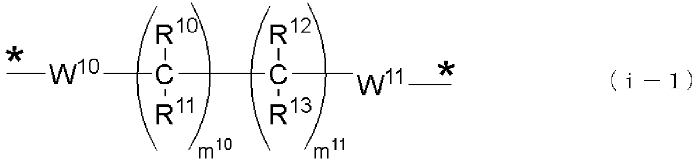
wherein "*" represents an attachment point; R¹⁰, R¹¹, R¹², and R¹³ each independently represent a hydrogen atom, a hydroxy group, or an organic group having 1 to 10 carbon atoms; W¹⁰ and W¹¹ each independently represent a single bond or a carbonyl group; and "m¹⁰" and "m¹¹" represent an integer of 0 to 10, provided that m¹⁰+m¹¹ ≥ 1, 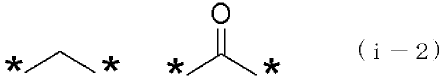
wherein "*" represents an attachment point, 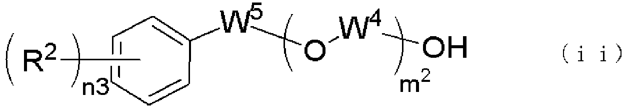
wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by one of the following formulae (ii-2); "m²" represents an integer of 2 to 10; and "n³" represents an integer of 0 to 5, 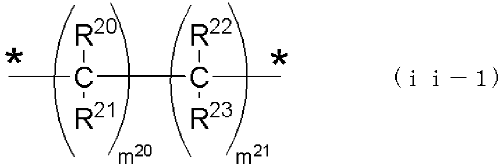
wherein "*" represents an attachment point; R²⁰, R²¹, R²², and R²³ each independently represent a hydrogen atom, a hydroxy group, or an organic group having 1 to 10 carbon atoms; and "m²⁰" and "m²¹" represent an integer of 0 to 10, provided that m²⁰+m²¹ ≥ 1, 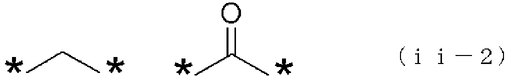
wherein "*" represents an attachment point, 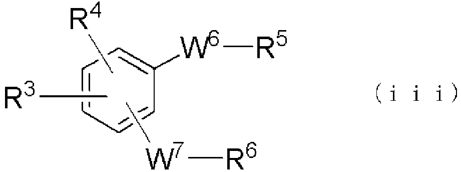
wherein R³ and R⁴ each independently represent a hydrogen atom, a hydroxy group, or an optionally substituted organic group having 1 to 10 carbon atoms and are optionally bonded to each other to form a cyclic structure; R⁵ and R⁶ each independently represent an organic group having 1 to 10 carbon atoms, R⁵ being a group containing an aromatic ring or a divalent group represented by the following general formula (iii-1); and W⁶ and W⁷ represent a single bond or a divalent group represented by one of the following formulae (iii-2), at least one of W⁶ and W⁷ being a divalent group represented by one of the following formulae (iii-2), 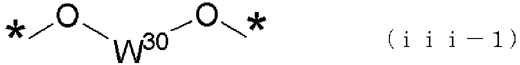
wherein "*" represents an attachment point; and W³⁰ represents an organic group having 1 to 4 carbon atoms, 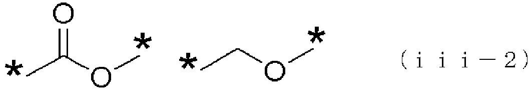
wherein "*" represents an attachment point.

When thermal flowability is imparted to the polymer (A) by the composition containing a flowability accelerator (D) containing one or more compounds selected from the general formulae (i) to (iii), the composition for forming a resist underlayer film is provided with high levels of both filling and planarizing properties.

The composition preferably further comprises one or more of (E) a surfactant, (F) an acid generator, and (G) a plasticizer.

A composition for forming a resist underlayer film containing one or more of the above additives has better coating property, dry etching resistance, and filling and planarizing properties.

The present invention also provides a patterning process for forming a pattern in a substrate to be processed, comprising the steps of:
(I-1) applying the above-described composition for forming a resist underlayer film onto a substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the above-described composition for forming a resist underlayer film onto a substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

The patterning process by way of the three-layer resist process makes it possible to form fine patterns on the body to be processed with a high degree of accuracy.

The present invention also provides a patterning process for forming a pattern in a substrate to be processed, comprising the steps of:
(III-1) applying the above-described composition for forming a resist underlayer film onto a substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

The patterning process by way of the four-layer resist process makes it possible to form fine patterns on the body to be processed with a high degree of accuracy.

Furthermore, in the inventive patterning process, the substrate to be processed can have a structure or a step with a height of 30 nm or more.

The inventive patterning process uses the inventive composition for forming a resist underlayer film with which it is possible to form a resist underlayer film having high filling and planarizing properties, and therefore, is particularly useful for fine processing of a substrate having such a structure or step.

The present invention also provides a method for forming a resist underlayer film that serves as an organic planarizing film employed in a semiconductor device manufacturing process, the method comprising:
spin-coating a substrate to be processed with the above-described composition for forming a resist underlayer film; and
heating the substrate coated with the composition for forming a resist underlayer film at a temperature of 100°C or higher and 800°C or lower for 10 to 600 seconds to form a cured film.

The present invention also provides a method for forming a resist underlayer film that serves as an organic planarizing film employed in a semiconductor device manufacturing process, the method comprising:
spin-coating a substrate to be processed with the above-described composition for forming a resist underlayer film; and
heating the substrate coated with the composition for forming a resist underlayer film under an atmosphere with an oxygen concentration of 1% or more and 21% or less to form a cured film.

Such a process accelerates the crosslinking reaction when the resist underlayer film is formed, thus more highly suppressing mixing with the resist upper layer film. Moreover, appropriate adjustment of the heating temperature, the time, and the oxygen concentration within the above ranges allows the resist underlayer film to have filling, planarizing, and curing properties suitable for the purpose.

The present invention also provides a method for forming a resist underlayer film that serves as an organic planarizing film employed in a semiconductor device manufacturing process, the method comprising:
spin-coating a substrate to be processed with the above-described composition for forming a resist underlayer film; and
heating the substrate coated with the composition for forming a resist underlayer film under an atmosphere with an oxygen concentration of less than 1% to form a cured film.

Such a process accelerates the crosslinking reaction when the resist underlayer film is formed without causing degradation of a substrate to be processed even when the substrate to be processed contains a material unstable to heating in an oxygen atmosphere, thus more highly and effectively suppressing mixing with the resist upper layer film.

In this event, the substrate to be processed preferably has a structure or a step with a height of 30 nm or more.

The inventive method for forming a resist underlayer film uses the inventive composition for forming a resist underlayer film with which it is possible to form a resist underlayer film having high filling and planarizing properties, and therefore, is particularly suitable for forming a resist underlayer film on a substrate having such a structure or step.

### ADVANTAGEOUS EFFECTS OF INVENTION

As explained above, the composition for forming a resist underlayer film, the patterning process, and the method for forming a resist underlayer film of the present invention are suitably used particularly in a multilayer resist process, including filling and planarization of a substrate to be processed having steps and irregularities, and are significantly useful in fine patterning for the manufacture of semiconductor devices. In particular, in a fine patterning process using a multilayer resist method in a semiconductor device manufacturing process, even on a substrate to be processed having a portion where filling and planarization are difficult, such as a portion with a dense fine pattern structure portion with a high aspect ratio typified by a DRAM memory under progressing miniaturization, filling can be performed without causing defects such as voids and peeling. Therefore, a resist underlayer film having excellent planarizing property can be formed. Furthermore, the present inventions exhibit better etching resistance than conventional resist underlayer films, and the effect can be exhibited particularly by heating in an atmosphere with an oxygen concentration of less than 1% by volume or less at a temperature higher than 450°C and 800°C or lower. Accordingly, it is possible to form a fine pattern in a body to be processed with even higher accuracy.

### BRIEF DESCRIPTION OF DRAWINGS

FIG. 1 is an explanatory view of an example (three-layer resist process) of the patterning process of the present invention.
FIG. 2 is an explanatory view of a method for evaluating the filling property.
FIG. 3 is an explanatory view of a method for evaluating the planarizing property.

### DESCRIPTION OF EMBODIMENTS

As stated above, there have been demands for the development of a composition for forming a resist underlayer film used for forming a resist underlayer film that makes it possible to transfer a resist pattern to a substrate to be processed with higher precision in a fine patterning process according to a multilayer resist method.

The present inventors have focused on methods for improving the dry etching resistance of a resist underlayer film at the time of substrate processing, made a start on the development of a composition for forming a resist underlayer film that can improve dry etching resistance dramatically, and studied earnestly. The present inventors have found out that, unlike in resist underlayer film materials having excellent heat resistance, in a high-carbon material in which thermal decomposition of a cured film by high-temperature baking occurs actively, decomposition and recombination of carbon bonds occur, and a dense cured film is obtained. The present inventors have studied earnestly further, and found out that a combination including a polymer having a structure represented by the general formula (1A), constituted almost entirely by carbon and hydrogen and a crosslinking agent represented by the general formula (B-1) can achieve a dense resist underlayer film, and exhibits much better dry etching resistance compared to conventional resist underlayer films. Thus, the present invention has been completed.

That is, the present invention is a composition for forming a resist underlayer film, comprising: (A) a polymer having a structure represented by the following general formula (1A); (B) a crosslinking agent represented by the following general formula (B-1); and (C) an organic solvent, wherein the polymer (A) contains no hydroxy groups and the crosslinking agent (B) is contained in an amount of 5 to 50 parts by mass relative to 100 parts by mass of the polymer (A), 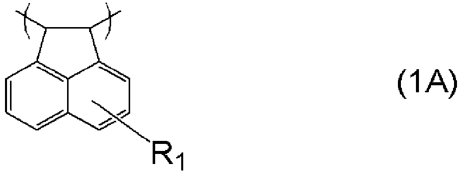
wherein R₁ represents a hydrogen atom, a halogen atom, or a linear, branched, or cyclic hydrocarbon group having 1 to 20 carbon atoms, 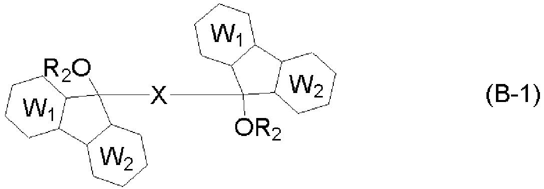
wherein W₁ and W₂ each independently represent a benzene ring or a naphthalene ring optionally having a substituent, each R₂ independently represents a hydrogen atom or a monovalent organic group having 1 to 20 carbon atoms, and X represents a group represented by one of the following formulae (2), 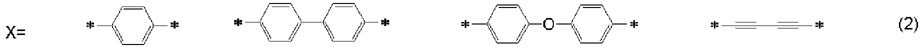
wherein "*" represents an attachment point.

Hereinafter, the present invention will be described in detail, but the present invention is not limited thereto. The present invention is defined by the scope of the claims, only.

### <Composition for Forming Resist Underlayer Film>

The inventive composition for forming a resist underlayer film contains: (A) a polymer having a structure represented by the following general formula (1A); (B) a crosslinking agent represented by the following general formula (B-1); and (C) an organic solvent, the polymer (A) containing no hydroxy groups and the crosslinking agent (B) being contained in an amount of 5 to 50 parts by mass relative to 100 parts by mass of the polymer (A).

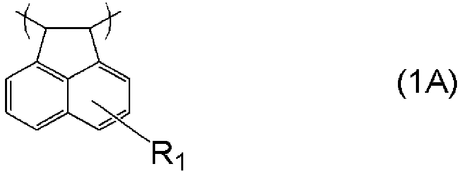

In the general formula (1A), R₁ represents a hydrogen atom, a halogen atom, or a linear, branched, or cyclic hydrocarbon group having 1 to 20 carbon atoms.

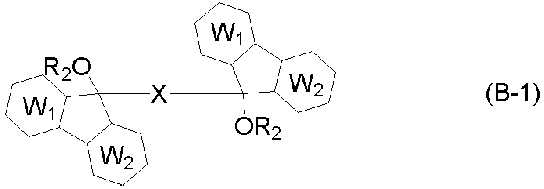

In the general formula (B-1), W₁ and W₂ each independently represent a benzene ring or a naphthalene ring optionally having a substituent, each R₂ independently represents a hydrogen atom or a monovalent organic group having 1 to 20 carbon atoms, and X represents a group represented by one of the following formulae (2).

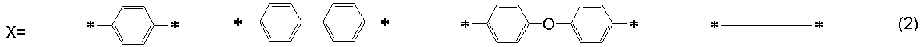

In the formulae (2), "*" represents an attachment point.

In the general formula (1A), R₁ represents a hydrogen atom, a halogen atom, or a linear, branched, or cyclic hydrocarbon group having 1 to 20 carbon atoms, preferably a hydrogen atom from the viewpoint of etching resistance.

In the general formula (B-1), W₁ and W₂ each independently represent a benzene ring or a naphthalene ring optionally having a substituent, each R₂ independently represents a hydrogen atom or a monovalent organic group having 1 to 20 carbon atoms, and X represents a group represented by one of the following formulae (2). From the viewpoint of the availability of raw materials, W₁ and W₂ are preferably each an unsubstituted benzene ring, and R₂ is preferably a hydrogen atom or an n-butyl group.

In the composition, the crosslinking agent (B) is contained in an amount of 5 to 50 parts by mass, preferably 10 to 40 parts by mass, more preferably 15 to 30 parts by mass relative to 100 parts by mass of the polymer (A).

If the amount of the crosslinking agent (B) contained in the composition is outside the above-described range, the thermosetting property of the composition for forming a resist underlayer film is degraded, causing degradation in the film thickness uniformity of the resist underlayer film and increase in the amount of sublimation product. When it is desired to enhance the etching resistance of the resist underlayer film at the time of substrate processing, the proportion of the polymer (A) is preferably increased, and when it is desired to enhance the film thickness uniformity of the resist underlayer film, the proportion of the crosslinking agent (B) is preferably increased. The proportions can be adjusted in accordance with the required performance.

The composition preferably further contains a polymer having structures represented by the following general formulae (1B).

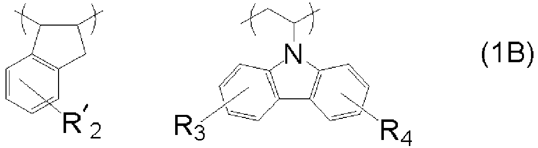

In the general formulae (1B), R'₂, R₃, and R₄ each independently represent a hydrogen atom, a halogen atom, or a linear, branched, or cyclic hydrocarbon group having 1 to 20 carbon atoms.

In the general formulae (1B), R'₂, R₃, and R₄ preferably each independently represent a hydrogen atom, a halogen atom, or a linear, branched, or cyclic hydrocarbon group having 1 to 20 carbon atoms. From the viewpoint of etching resistance, R'₂, R₃, and R₄ more preferably each represent a hydrogen atom.

The polymer having the structures represented by the general formulae (1B) is not particularly limited as long as it is contained in the composition, and may be a mixed composition of a polymer having the structure represented by the general formula (1A) and a polymer having the structures represented by the general formulae (1B) or may be a copolymer of the structure represented by the general formula (1A) and the structures represented by the general formulae (1B).

When the inventive composition for forming a resist underlayer film further contains a polymer having structures shown by the general formulae (1B), thermal flowability is improved, and it is possible to provide a composition for forming a resist underlayer film having excellent filling and planarizing properties against stepped substrates.

In the composition for forming a resist underlayer film, the polymer (A) preferably has structures represented by the following general formulae (1C).

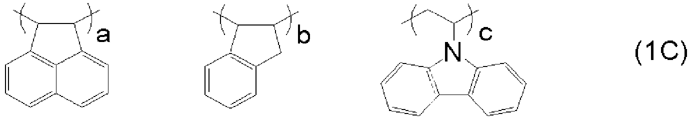

In the general formulae (1C), "a", "b", and "c" satisfy a+b+c = 1, 0.5 ≤ a ≤ 0.9, and 0.1 ≤ b+c ≤ 0.5.

In the general formulae (1C), "a", "b", and "c" preferably satisfy a+b+c = 1, 0.5 ≤ a ≤ 0.9, and 0.1 ≤ b+c ≤ 0.5, more preferably 0.7 ≤ a ≤ 0.9 and 0.1 ≤ b+c ≤ 0.3.

The polymer (A) preferably has a weight-average molecular weight Mw of 500 to 5,000, more preferably 1,000 to 4,500, and further preferably 2,000 to 4,000 as measured by gel permeation chromatography in terms of polystyrene. When the Mw is 500 or more, the amount of sublimation product is small, and film thickness uniformity is not degraded. When the Mw is 5,000 or less, the solvent solubility of the polymer is not degraded, and therefore, the polymer is not precipitated over time. Thus, this range is preferable from the viewpoint of storage stability. In addition, flowability is not degraded, and therefore, filling property and planarization property are not degraded either.

When the weight-average molecular weight is as described, the thermal flowability of the resist underlayer film material is excellent, and therefore, when the polymer is contained in a resist underlayer film material, not only is it possible to fill favorably fine structures formed on a substrate, it is possible to form a resist underlayer film to planarize the entire substrate.

The polymer (A) can be obtained by polymerizing a polymerizable monomer by a known method. When obtaining the polymer, it is also possible to synthesize the polymer by polymerizing monomers protected by a protecting group as necessary, and then performing a deprotection reaction as necessary. Reaction methods for obtaining the polymer are not particularly limited, and it is possible to employ a method such as radical polymerization and cationic polymerization and select the method appropriately depending on the reactivity of the monomer and so forth.

When radical polymerization is to be employed, there is a method of mixing a monomer having a polymerizable unsaturated bond and adding a radical initiator into the solvent to perform thermal polymerization. The polymer can be thus obtained. Various polymerization conditions can be selected in accordance with the monomers to be used, the target molecular weight, etc. Specific examples of the solvent to be used in the polymerization include toluene, benzene, tetrahydrofuran, diethyl ether, dioxane, 2-butanone, methylisobutylketone, propylene glycol monomethyl ether acetate, cyclohexanone, γ-butyrolactone, ethyl acetate, and butyl acetate. Examples of the polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, and lauroyl peroxide. As a chain transfer agent, it is also possible to add, upon polymerization, a thiol such as octanethiol and 2-mercaptoethanol. The polymerization reaction can be performed preferably at a temperature of 40°C to the boiling point of the reaction solvent. The reaction time can be 0.5 to 100 hours, preferably 1 to 48 hours.

When cationic polymerization is to be employed, there is a method of mixing a monomer having a polymerizable unsaturated bond and adding a cationic polymerization initiator to perform polymerization. The polymer can be thus obtained. Various polymerization conditions can be selected in accordance with the monomers to be used, the target molecular weight, etc. Specific examples of the solvent to be used in the polymerization include hexane, heptane, octane, toluene, methylene chloride, 1,2-dichloroethane, ethyl ether, butyl ether, etc. As a catalyst to be used as the cationic polymerization initiator, it is possible to use a protonic acid, such as acid, sulfuric acid, perchloric acid, trifluoroacetic acid, methanesulfonic acid, trifluoromethanesulfonic acid, chlorosulfonic acid, and fluorosulfonic acid; a Lewis acid, such as boron trifluoride, aluminum chloride, titanium tetrachloride, stannic chloride, and ferric chloride; etc. When a Lewis acid is to be used as a catalyst, the presence of a source of proton supply, such as acid, water, or alcohol, at about the same number of moles as the catalyst improves cationic polymerization activity. Therefore, such a material can also be contained. The polymerization reaction is not particularly limited as long as the temperature is a temperature at which the reaction progresses, but it is preferable to perform the reaction while heating at -10°C to the boiling point of the reaction solvent. The reaction time can be 0.5 to 100 hours, preferably 1 to 48 hours.

The method for obtaining the polymer (A) is preferably cationic polymerization. In radical polymerization, terminal structures containing heteroatoms originating from a radical initiator are introduced into the polymer, and the heteroatoms, such as oxygen and nitrogen, other than carbon, degrade etching resistance. In cationic polymerization, however, such inconvenience does not arise. Therefore, the method for obtaining the polymer is preferably cationic polymerization, from the viewpoint of etching resistance.

The Mw/Mn (that is, the dispersity) of the crosslinking agent (B) preferably satisfies 1.00 ≤ Mw/Mn ≤ 1.25, where Mw is a weight-average molecular weight and Mn is a number-average molecular weight measured by gel permeation chromatography in terms of polystyrene.

When the dispersity is within the above range, the thermal flowability of a resist underlayer film material does not decrease. Therefore, when the crosslinking agent is contained in a resist underlayer film material, fine structures formed on the substrate can be filled, and moreover, it is possible to form a resist underlayer film that is flat on the entire substrate. From the definition, Mw/Mn is 1.00 in the case of a monomolecular compound, but because of separation in GPC, the measured value exceeds 1.00 in some cases. Generally, it is extremely difficult to bring the Mw/Mn of a polymer having a repeating unit close to 1.00 unless a special polymerization method is used. Such a polymer has a distribution of Mw, and Mw/Mn exceeds 1. In the present invention, the range 1.00 ≤ Mw/Mn ≤ 1.25 is defined as an index to indicate monomerism in order to distinguish between monomolecular compounds and polymers.

### <(C) Organic Solvent>

The organic solvent (C) that can be used in the inventive composition for forming a resist underlayer film is not particularly limited as long as it dissolves the above-described polymer (A) and crosslinking agent (B), and when contained, a flowability accelerator (D), a surfactant (E), an acid generator (F), a plasticizer (G), other additives etc., which will be described later.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the polymer (A).

### <(D) Flowability Accelerator>

The composition preferably contains a flowability accelerator (D) having a weight reduction rate of less than 30% at 30°C to 190°C and a weight reduction rate of 98% or more at 30°C to 350°C.

A flowability accelerator having a weight reduction rate of less than 30% at 30°C to 190°C and a weight reduction rate of 98% or more at 30°C to 350°C sufficiently maintains low viscosity since evaporation during a heat treatment is suppressed. Therefore, such a flowability accelerator is preferable since it has excellent thermal flowability and little flowability accelerator remains in the resist underlayer film after baking. In the present description, the weight reduction rate is based on a value obtained by TG (thermogravimetry) using a differential thermal analyzer.

The upper limit of the temperature range at which the weight reduction rate of the flowability accelerator (D) is less than 30% is further preferably 210°C, and further preferable 230°C. By setting the temperature range at which the weight reduction rate of the flowability accelerator is less than 30% to the above-described ranges, filling and planarizing properties can be enhanced further.

The temperature at which the weight reduction rate of the flowability accelerator (D) is 98% or more is further preferably 330°C, and particularly preferably 310°C. By setting the temperature at which the weight reduction rate of the flowability accelerator is 98% or more to the above-described temperature ranges, the flowability accelerator that remains in the resist underlayer film after baking can be reduced.

When the above-described flowability accelerator (D) is contained, the thermal flowability of the composition for forming a resist underlayer film between the start of the heat treatment and being cured by a crosslinking reaction is enhanced. Therefore, excellent filling and planarizing properties can be achieved. Meanwhile, the flowability accelerator (D) is reduced by evaporation and so forth in the heat treatment, and therefore, there is no risk of etching resistance and optical characteristics being degraded.

Further preferable forms of the flowability accelerator (D) include flowability accelerators containing one or more compounds selected from the following general formulae (i) to (iii).

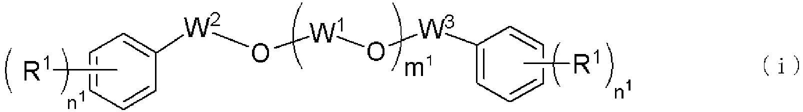

In the general formula (i), each R¹ independently represents a hydrogen atom, a hydroxy group, or an optionally substituted organic group having 1 to 10 carbon atoms; W¹ represents a phenylene group, or a divalent group represented by the following general formula (i-1); W² and W³ each independently represent a single bond or a divalent group represented by one of the following formulae (i-2); "m¹" represents an integer of 1 to 10; and "n¹" represents an integer of 0 to 5.

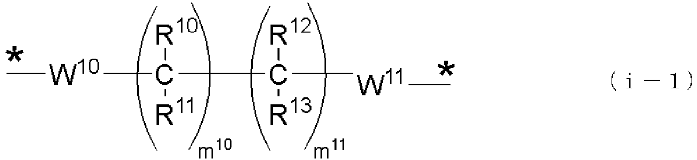

In the general formula (i-1), "*" represents an attachment point; R¹⁰, R¹¹, R¹², and R¹³ each independently represent a hydrogen atom, a hydroxy group, or an organic group having 1 to 10 carbon atoms; W¹⁰ and W¹¹ each independently represent a single bond or a carbonyl group; and "m¹⁰" and "m¹¹" represent an integer of 0 to 10, provided that m¹⁰+m¹¹ ≥ 1.

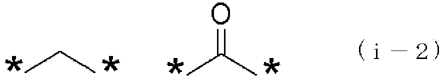

In the formulae (i-2), "*" represents an attachment point.

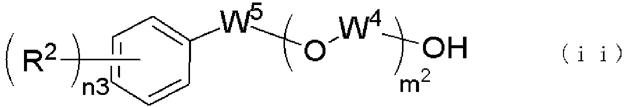

In the general formula (ii), each R² independently represents a hydrogen atom or an optionally substituted organic group having 1 to 10 carbon atoms; W⁴ represents a divalent group represented by the following general formula (ii-1); W⁵ represents a single bond or a divalent group represented by one of the following formulae (ii-2); "m²" represents an integer of 2 to 10; and "n³" represents an integer of 0 to 5.

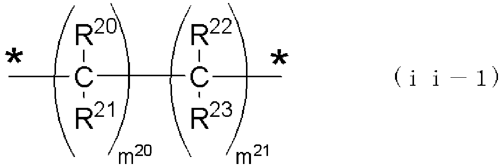

In the general formula (ii-1), "*" represents an attachment point; R²⁰, R²¹, R²², and R²³ each independently represent a hydrogen atom, a hydroxy group, or an organic group having 1 to 10 carbon atoms; and "m²⁰" and "m²¹" represent an integer of 0 to 10, provided that m²⁰+m²¹ ≥ 1.

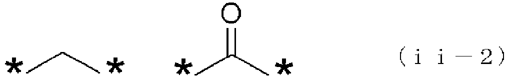

In the formulae (ii-2), "*" represents an attachment point.

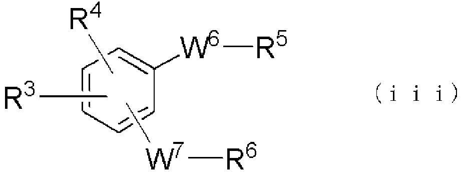

In the general formula (iii), R³ and R⁴ each independently represent a hydrogen atom, a hydroxy group, or an optionally substituted organic group having 1 to 10 carbon atoms and are optionally bonded to each other to form a cyclic structure; R⁵ and R⁶ each independently represent an organic group having 1 to 10 carbon atoms, R⁵ being a group containing an aromatic ring or a divalent group represented by the following general formula (iii-1); and W⁶ and W⁷ represent a single bond or a divalent group represented by one of the following formulae (iii-2), at least one of W⁶ and W⁷ being a divalent group represented by one of the following formulae (iii-2).

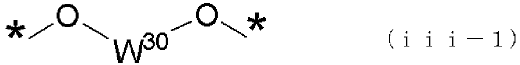

In the general formula (iii-1), "*" represents an attachment point; and W³⁰ represents an organic group having 1 to 4 carbon atoms.

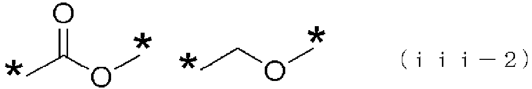

In the formulae (iii-2), "*" represents an attachment point.

In the general formula (i), each R¹ independently represents a hydrogen atom, a hydroxy group, or an optionally substituted organic group having 1 to 10 carbon atoms. Here, "organic group" in the present invention means a group containing at least one carbon atom and further containing a hydrogen atom, and a nitrogen, oxygen, sulfur, silicon, halogen atom, etc. may also be contained.

R¹ may be of one kind, or a plurality of kinds may be present. More specific examples of R¹ include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, a hydrogen atom is more preferable.

W¹ represents a phenylene group or a divalent group represented by the general formula (i-1). W² and W³ each independently represent a single bond or a divalent group represented by one of the formulae (i-2). "m¹" represents an integer of 1 to 10; and each "n¹" independently represents an integer of 0 to 5.

R¹⁰, R¹¹, R¹², and R¹³ each independently represent a hydrogen atom, a hydroxy group, or an organic group having 1 to 10 carbon atoms. More specific examples include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, a hydrogen atom and a methyl group are more preferable, and a hydrogen atom is further preferable.

W¹⁰ and W¹¹ each independently represent a single bond or a carbonyl group. "m¹⁰" and "m¹¹" represent an integer of 0 to 10, provided that m¹⁰+m¹¹ ≥ 1.

In the general formula (ii), each R² independently represents a hydrogen atom or an optionally substituted organic group having 1 to 10 carbon atoms.

R² may be of one kind, or a plurality of kinds may be present. More specific examples of R² include a hydrogen atom, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, a hydrogen atom is more preferable.

W⁴ represents a divalent group represented by the general formula (ii-1). W⁵ represents a single bond or a divalent group represented by one of the formulae (ii-2). "m²" represents an integer of 2 to 10; and "n³" represents an integer of 0 to 5.

R²⁰, R²¹, R²², and R²³ each independently represent a hydrogen atom, a hydroxy group, or an optionally substituted organic group having 1 to 10 carbon atoms. More specific examples include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a t-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, a hydrogen atom and a methyl group are more preferable, and a hydrogen atom is further preferable.

"m²⁰" and "m²¹" each represent an integer of 0 to 10, and satisfy m²⁰+m²¹ ≥ 1.

In the general formula (iii), R³ and R⁴ each independently represent a hydrogen atom, a hydroxy group, or an optionally substituted organic group having 1 to 10 carbon atoms. More specific examples include a hydrogen atom, a hydroxy group, a methyl group, an ethyl group, a vinyl group, a 2,2,2-trifluoroethyl group, a propyl group, an isopropyl group, an allyl group, a butyl group, an s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, an s-butoxy group, a norbornyl group, an adamantyl group, a phenyl group, a toluyl group, a xylyl group, a naphthyl group, a benzyl group, a 2-furanyl group, and a 2-tetrahydrofuranyl group. In particular, a hydrogen atom is more preferable.

R⁶ represents an organic group having 1 to 10 carbon atoms. R⁵ represents an organic group having 1 to 10 carbon atoms, and is a group containing an aromatic ring or a divalent group represented by the general formula (iii-1). Examples of the organic group having 1 to 10 carbon atoms include the groups given as examples of R³ and R⁴.

W⁶ and W⁷ represent a single bond or a divalent group represented by one of the formulae (iii-2), and at least one of W⁶ and W⁷ is a divalent group represented by one of the formulae (iii-2).

W³⁰ represents an organic group having 1 to 4 carbon atoms. More specific examples include a methylene group, an ethylene group, a propylene group, a butylene group, a trimethylene group, and a tetramethylene group. In particular, an ethylene group is more preferable.

Further specific examples of the compound shown by the general formula (i) include the following, but are not limited thereto.

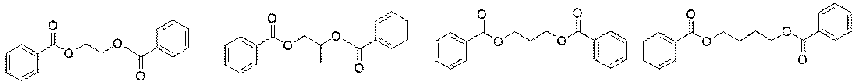

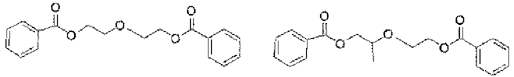

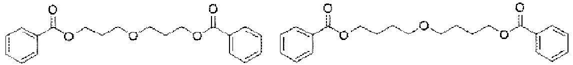

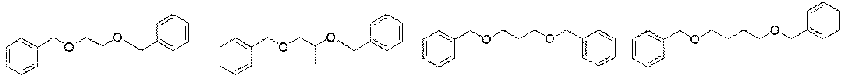

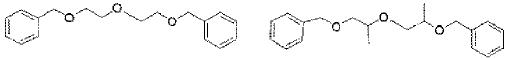

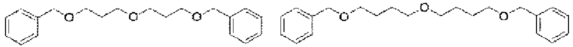

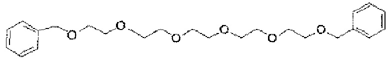

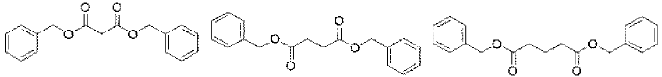

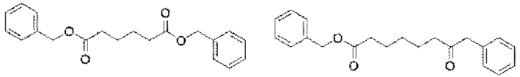

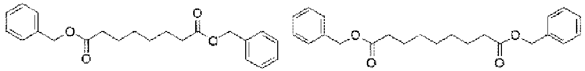

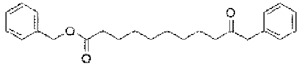

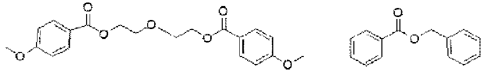

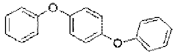

Further specific examples of the compound shown by the general formula (ii) include the following, but are not limited thereto.

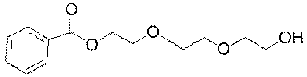

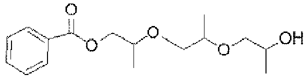

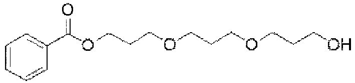

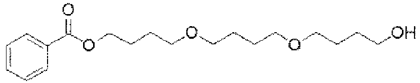

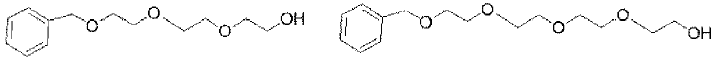

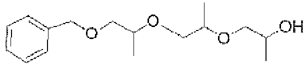

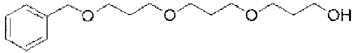

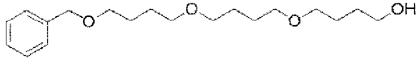

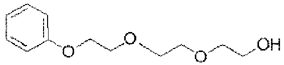

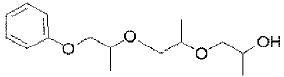

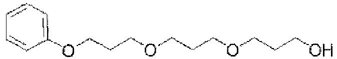

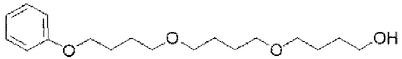

Further specific examples of the compound shown by the general formula (iii) include the following, but are not limited thereto.

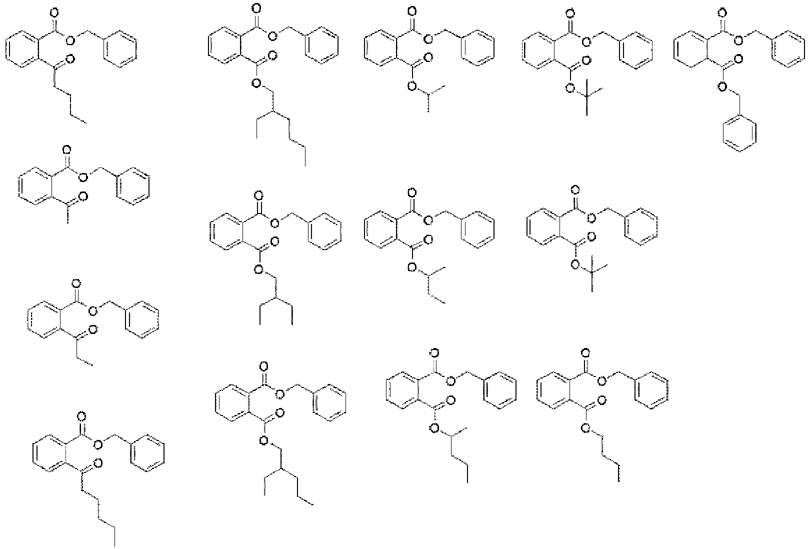

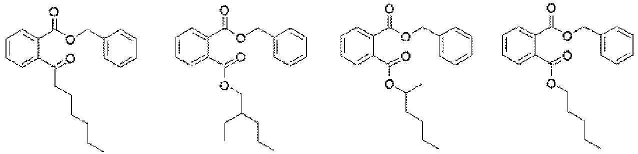

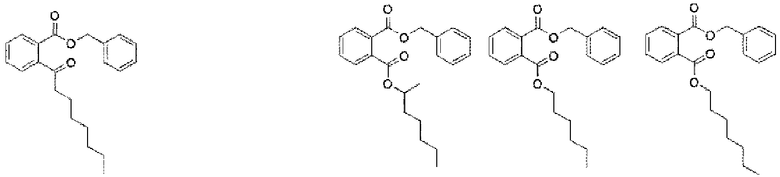

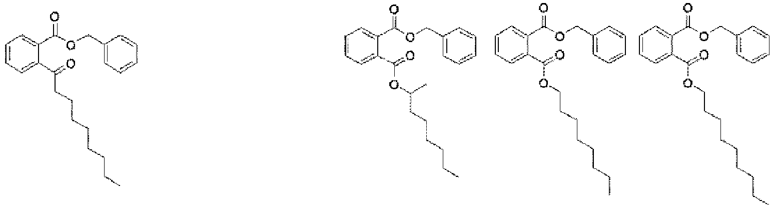

Comprehensively considering the film-formability, properties of filling and planarizing a substrate, etc. of the composition for forming a resist underlayer film, the flowability accelerator (D) to be contained in the inventive composition for forming a resist underlayer film is preferably an aromatic-group-containing compound having a benzyl group or a benzoyl group, particularly preferably an aromatic-group-containing compound shown below.
(i) (Poly)ethylene glycol dibenzoate
(ii) (Poly)ethylene glycol dibenzyl ether
(iii) (Poly)propylene glycol dibenzyl ether
(iv) (Poly)butylene glycol dibenzyl ether
(v) Linear aliphatic dibenzyl dicarboxylate
(vi) (Poly)ethylene glycol monobenzyl ether
(vii) (Poly)phenyl ether

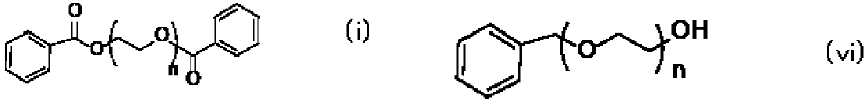

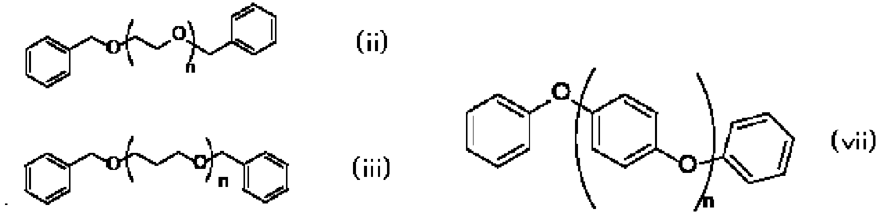

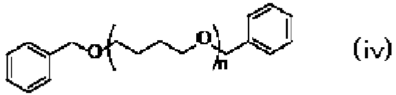

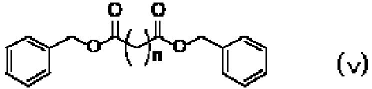

Note that the "n" in the above formulae is an integer at which the molecular weight is within the range of 500 or less, and applies only in these formulae.

The flowability accelerator (D) that can be contained in the inventive composition for forming a resist underlayer film has a structure having both a hydrophobic moiety including an aromatic ring and a hydrophilic moiety including a (D-1) structure. Therefore, the flowability accelerator has excellent compatibility with the polymer (A), the crosslinking agent (B), the organic solvent (C), and other additives, and the flowability of the composition can be improved without degradation in film-formability or storage stability.

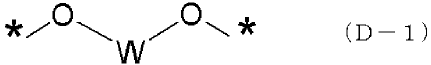

In the formula, "*" represents an attachment point, and W represents an organic group having 1 to 4 carbon atoms.

The amount of the flowability accelerator (D) to be contained is preferably 5 to 100 parts by mass, more preferably 10 to 50 parts by mass relative to 100 parts by mass of the polymer (A). When the amount of the flowability accelerator (D) contained is 10 mass% or more, the flowability of the composition for forming a resist underlayer film can be sufficiently enhanced. When the amount of the flowability accelerator (D) contained relative to the polymer (A) is within the above ranges, a sufficient effect of enhancing the thermal flowability of the resist underlayer film can be achieved, and the film-formability and dry etching resistance of the obtained coating film are also excellent.

One kind of the flowability accelerator (D) can be used, or two or more kinds can be used in combination.

### <Other Components>

### [Crosslinking Agent]

The inventive composition for forming a resist underlayer film can also contain a common crosslinking agent besides the crosslinking agent (B), which is characterized by the structure of the general formula (B-1). The crosslinking agent to be used is not particularly limited, and various known crosslinking agents can be widely used. Examples thereof include polynuclear phenol-based, such as methylol or alkoxymethyl-based crosslinking agents (polynuclear phenol-based crosslinking agents), melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, an oxazoline-based crosslinking agents, and epoxy-based crosslinking agents. When the crosslinking agent is contained, the contained amount is preferably 1 to 50 parts by mass, more preferably 5 to 30 parts by mass relative to 100 parts by mass of the polymer (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl) adipic acid amide. Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

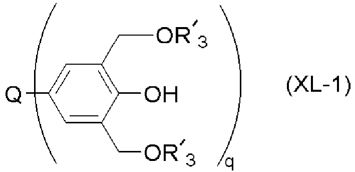

In the general formula (XL-1), Q represents a single bond or a q-valent hydrocarbon group having 1 to 20 carbon atoms. R'₃ represents a hydrogen atom or an alkyl group having 1 to 20 carbon atoms. "q" represents an integer of 1 to 5.

Q represents a single bond or a hydrocarbon group having a valency of "q" and having 1 to 20 carbon atoms. "q" represents an integer of 1 to 5, more preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R'₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, a hexamethoxymethylated derivative of triphenolmethane, triphenolethane, 1,1,1,-tris(4-hydroxyphenyl) ethane, and tris(4-hydroxyphenyl)-1-ethyl-4-isopropylbenzene are preferable from the viewpoint of improving the curability and film thickness uniformity of the resist underlayer film. R'₃ is as defined above.

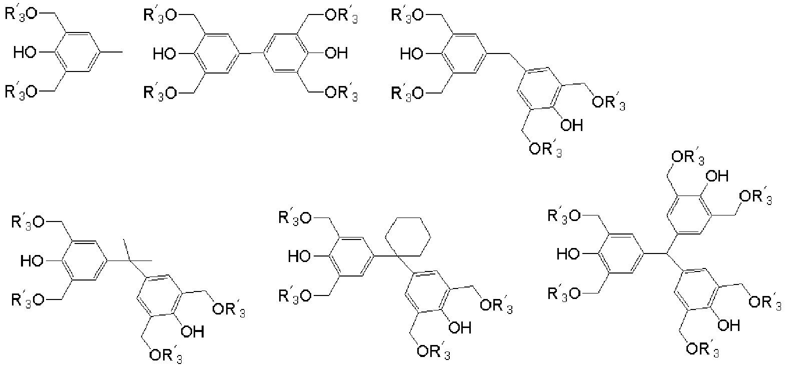

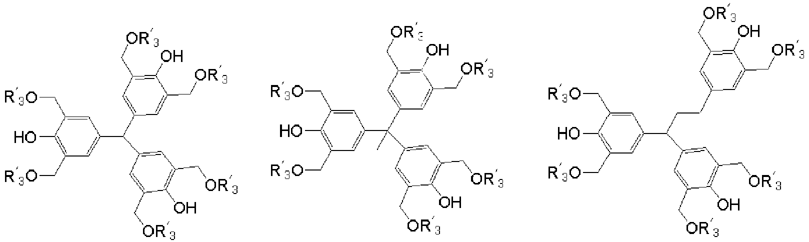

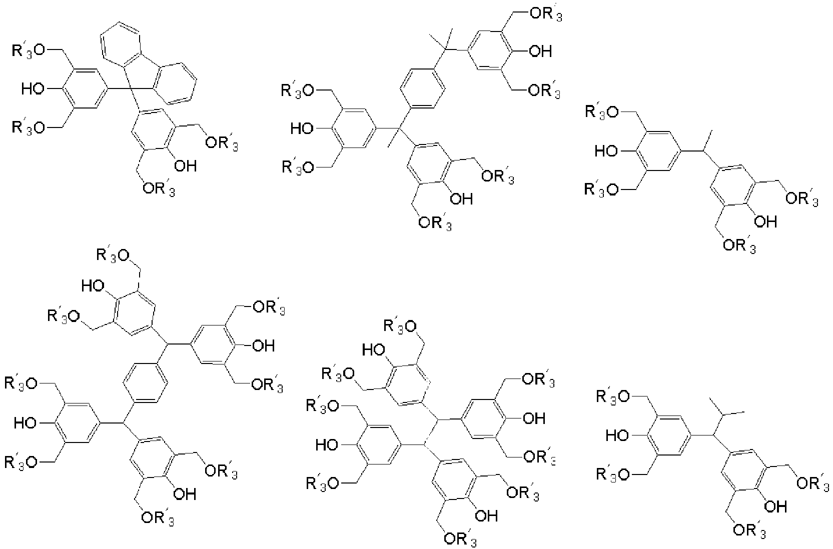

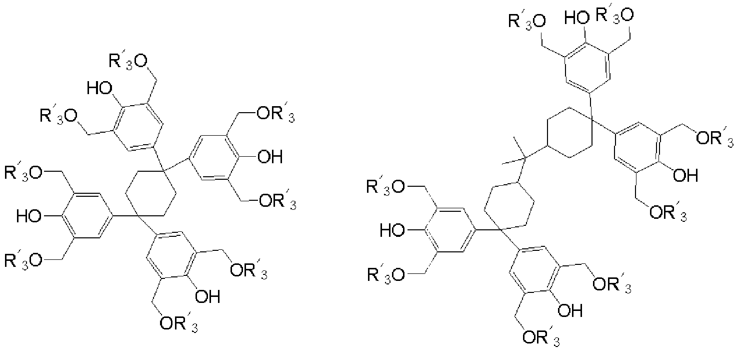

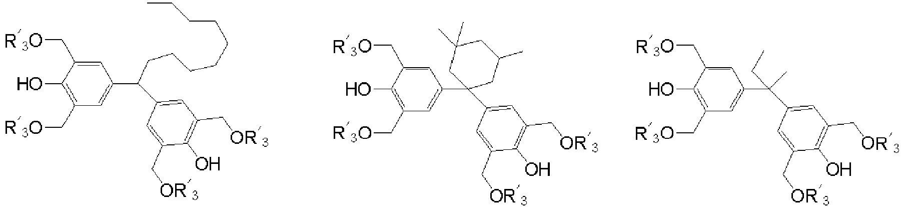

### [(E) Surfactant]

A surfactant (E) may be contained in the inventive composition for forming a resist underlayer film in order to improve coating property in spin-coating. Examples of the surfactant (E) include those disclosed in paragraphs [0142] to [0147] of JP2009-269953A. When the surfactant (E) is contained, the contained amount is preferably 0.01 to 10 parts by mass, more preferably 0.05 to 5 parts by mass per 100 parts by mass of the polymer (A).

### [(F) Acid Generator]

An acid generator (F) may be contained in the inventive composition for forming a resist underlayer film in order to promote a curing reaction further. The acid generator (F) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator (F) can be used, or two or more kinds can be used in combination. When the acid generator (F) is contained, the contained amount is preferably 0.05 to 50 parts by mass, more preferably 0.1 to 10 parts by mass relative to 100 parts by mass of the polymer (A).

### [(G) Plasticizer]

A plasticizer (G) may be contained in the inventive composition for forming a resist underlayer film in order to improve further the planarizing and filling properties. The plasticizer (G) is not particularly limited, and various known plasticizers can be widely used. Examples of the plasticizer include low molecular weight compounds, such as phthalate esters, adipate esters, phosphate esters, trimellitate esters, and citrate esters; and polymers, such as polyether-based polymers, polyester-based polymers, and polyacetal-based polymers disclosed in JP2013-253227A. When the plasticizer (G) is contained, the contained amount is preferably 1 to 100 parts by mass, more preferably 5 to 30 parts by mass, per 100 parts by mass of the polymer (A).

In addition, in the inventive composition for forming a resist underlayer film, it is preferable to use, as an additive for imparting filling and planarizing properties in the same manner as the plasticizer, for example, a liquid additive having a polyethylene glycol or polypropylene glycol structure, or a thermo-decomposable polymer having a weight reduction rate of 40% by mass or more at 30°C to 250°C and a weight-average molecular weight of 300 to 200,000. This thermo-decomposable polymer preferably contains a repeating unit having an acetal structure represented by the following general formula (DP1) or (DP1a).

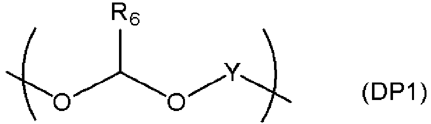

In the general formula (DP1), R₆ represents a hydrogen atom or an optionally substituted saturated or unsaturated monovalent organic group having 1 to 30 carbon atoms. Y represents a saturated or unsaturated divalent organic group having 2 to 30 carbon atoms.

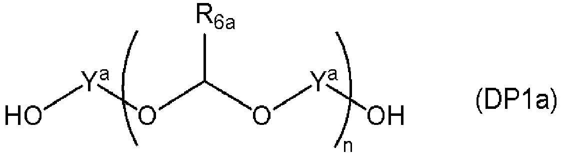

In the general formula (DP1a), R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Patterning Process Using Composition for Forming Resist Underlayer Film>

The present invention provides, as a patterning process according to a two-layer resist process using the above-described composition for forming a resist underlayer film, a patterning process for forming a pattern in a substrate to be processed, including the steps of:
(I-1) applying the above-described composition for forming a resist underlayer film onto a substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The resist upper layer film in the two-layer resist process described above is preferably a photosensitive organic metal oxide film. The photosensitive organic metal oxide film exhibits etching resistance with respect to oxygen-based gas; therefore, the dry etching of the resist underlayer film that is performed while using the resist upper layer film as a mask in the two-layer resist process is preferably performed using an etching gas mainly containing an oxygen-based gas.

The present invention also provides, as a patterning process using a three-layer resist process using the above-described composition for forming a resist underlayer film, a patterning process for forming a pattern in a substrate to be processed, including the steps of:
(II-1) applying the above-described composition for forming a resist underlayer film onto a substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

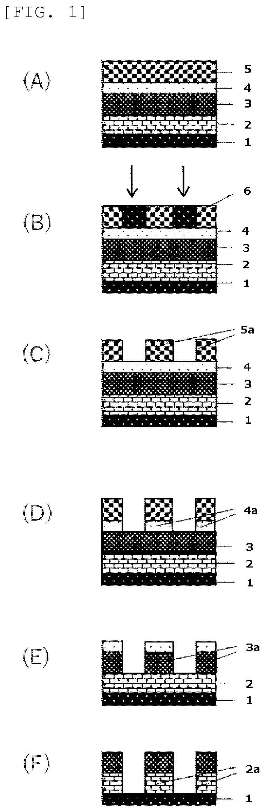

With reference to FIG. 1, a patterning process according to a three-layer resist process will be described. The present invention provides, as a patterning process according to a three-layer resist process using such a composition for forming a resist underlayer film, the patterning process including:
forming a resist underlayer film 3 on a layer 2 to be processed on a substrate 1 to be processed by using the composition for forming a resist underlayer film, forming a silicon-containing resist middle layer film 4 on the resist underlayer film by using a silicon-containing resist middle layer film material, and forming a resist upper layer film 5 on the silicon-containing resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a resist underlayer film pattern 3a to the resist underlayer film by dry etching while using the silicon-containing resist middle layer film having the transferred pattern as a mask as in FIG. 1(E); and
processing the layer to be processed on the substrate to be processed while using the resist underlayer film having the formed pattern as a mask to form a pattern 2a on the substrate 1 to be processed as in FIG. 1(F).

The silicon-containing resist middle layer film in the three-layer resist process exhibits etching resistance with respect to an oxygen-based gas. Therefore, the dry etching of the resist underlayer film that is performed while using the silicon-containing resist middle layer film as a mask in the three-layer resist process is preferably performed using an etching gas mainly containing an oxygen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a composition for forming a resist underlayer film, the patterning process including the steps of:
forming a resist underlayer film on a substrate to be processed by using the above-described composition for forming a resist underlayer film;
forming a silicon-containing resist middle layer film on the resist underlayer film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the transferred pattern as a mask; and
processing the substrate to be processed while using the resist underlayer film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern can be formed on a substrate, at least, by:
forming a resist underlayer film on a body to be processed (substrate to be processed) by using the inventive composition for forming a resist underlayer film;
forming an inorganic hard mask middle layer film selected from a silicon oxide film, a silicon nitride film, and a silicon oxynitride film on the resist underlayer film;
forming a resist upper layer film on the inorganic hard mask middle layer film by using a photoresist composition;
forming a circuit pattern in the resist upper layer film;
etching the inorganic hard mask middle layer film while using the resist upper layer film having the formed pattern as a mask;
etching the resist underlayer film while using the inorganic hard mask middle layer film having the formed pattern as a mask; and
furthermore, etching the body to be processed while using the resist underlayer film having the formed pattern as a mask to form the pattern in the body to be processed.

As described above, when the inorganic hard mask middle layer film is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most favorably used as the inorganic hard mask middle layer film. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300 to 500°C. Thus, the resist underlayer film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

The present invention also provides a patterning process for forming a pattern in a substrate to be processed, including the steps of:
(III-1) applying the above-described composition for forming a resist underlayer film onto a substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to a CVD method or an ALD method.

In a case where the photoresist composition is formed by a spin-coating method, prebaking is conducted after applying the photoresist composition. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the photoresist composition is to be formed by a deposition treatment according to a CVD method or an ALD method, the photoresist composition is a metal-oxide-containing film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic-oxide-containing film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal-oxide-containing film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist upper layer film pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the resist underlayer film is etched while using the obtained silicon-containing resist middle layer film pattern or inorganic hard mask middle layer film pattern as a mask. The etching of the resist underlayer film is preferably performed using an etching gas mainly containing an oxygen-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained by using the inventive composition for forming a resist underlayer film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the inventive patterning process, it is possible to use, as the substrate to be processed, a substrate having a structure or a step having a height of 30 nm or more.

### <Method for Forming Resist Underlayer Film>

The present invention provides a method for forming a resist underlayer film that serves as an organic planarizing film employed in a semiconductor device manufacturing process, the method including:
spin-coating a substrate to be processed with the above-described composition for forming a resist underlayer film; and
heating the substrate coated with the composition for forming a resist underlayer film at a temperature of 100°C or higher and 800°C or lower for 10 to 600 seconds to form a cured film.

The present invention also provides a method for forming a resist underlayer film that serves as an organic planarizing film employed in a semiconductor device manufacturing process, the method including:
spin-coating a substrate to be processed with the above-described composition for forming a resist underlayer film; and
heating the substrate coated with the composition for forming a resist underlayer film under an atmosphere with an oxygen concentration of 1% or more and 21% or less to form a cured film.

Alternatively, the present invention provides a method for forming a resist underlayer film that serves as an organic planarizing film employed in a semiconductor device manufacturing process, the method including:
spin-coating a substrate to be processed with the above-described composition for forming a resist underlayer film; and
heating the substrate coated with the composition for forming a resist underlayer film under an atmosphere with an oxygen concentration of less than 1% to form a cured film.

In the inventive method for forming a resist underlayer film, the substrate to be processed is coated with the composition for forming a resist underlayer film by a spin-coating method or the like. Using the spin-coating or the like ensures a desirable filling property. After spin-coating, baking is performed so as to evaporate the organic solvent and promote a crosslinking reaction to prevent mixing with the resist upper layer film or the resist middle layer film. The baking is preferably performed at a temperature of 100°C or higher and 800°C or lower, preferably 300°C or higher and 800°C and lower, and more preferably 450°C or higher and 800°C or lower for 10 seconds to 600 seconds, preferably 10 to 300 seconds. By adjusting the baking temperature and time appropriately within the above ranges, it is possible to achieve planarizing and filling properties and curing property, such as dry etching resistance and heat resistance, suitable for the purpose. By performing the baking within the temperature range of 450°C or higher and 800°C or lower, particularly excellent dry etching resistance can be achieved. When the baking temperature is 100°C or higher, curing progresses sufficiently, and mixing with the resist upper layer film or the resist middle layer film can be suppressed. When the baking temperature is 800°C or lower, thermal decomposition of the base resin can be suppressed, and therefore, film thickness does not decrease, and a uniform film surface can be achieved.

As the atmosphere during the baking, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

In the method for forming a resist underlayer film using the inventive composition for forming a resist underlayer film, it is preferable to use a substrate to be processed having a structure or step having a height of 30 nm or more. As described above, the inventive composition for forming a resist underlayer film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and further preferably 100 nm or more. In the method of processing a stepped substrate having a pattern of the above-described height, filling and planarizing by forming a film of the inventive composition for forming a resist underlayer film makes it possible to achieve a uniform film thickness in the subsequently formed resist middle layer film and resist upper layer film. Therefore, it is easy to ensure the exposure depth margin (DOF) at the time of photolithography, which is very desirable.

### EXAMPLES

The present invention is more specifically described below with reference to Synthesis Examples, Comparative Synthesis Examples, Examples, and Comparative Examples. However, the present invention is not limited to these Examples. The present invention is defined by the scope of the appended claims, only. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### Synthesis Examples: Synthesis of Polymer (A)

### [Synthesis Example 1] Synthesis of Polymer (A1)

Under a nitrogen atmosphere, 3.8 g of methanesulfonic acid and 30 g of methylene chloride were mixed together and homogenized at an internal temperature of 30°C. Subsequently, a mixed solution of 30.0 g of acenaphthylene and 60.0 g of methylene chloride was added dropwise over 1 hour, and the mixture was heated and stirred at an internal temperature of 35°C for 24 hours. The resultant was cooled to room temperature, and then 300 g of toluene was added thereto. The resultant was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 28.7 g of a polymer (A1).

The weight-average molecular weight (Mw) and the dispersity (Mw/Mn) were determined by GPC, and the following results were obtained.
(A1): Mw=2,400, Mw/Mn=1.93

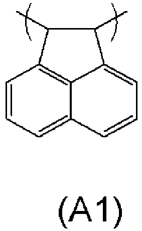

### [Synthesis Example 2] Synthesis of Polymer (A2)

37.5 g of propylene glycol monomethyl ether acetate (PGMEA) was heated and stirred under a nitrogen atmosphere at 80°C. A mixture of 50.0 g of acenaphthylene and 82.5 g of PGMEA and a mixture of 3.8 g of dimethyl 2,2-azobis(2-methylpropionate) and 30.0 g of PGMEA were added thereto simultaneously and separately over 2 hours. The obtained mixture was further heated and stirred for 24 hours, and then cooled to room temperature. The reaction solution was added dropwise to 750 g of methanol to precipitate a polymer. The precipitated crystal was separated by filtration, washed twice with 300 g of methanol, and collected. The collected crystal was vacuum-dried at 70°C to obtain 48.3 g of a polymer (A2).

The weight-average molecular weight (Mw) and the dispersity (Mw/Mn) were determined by GPC, and the following results were obtained.
(A2): Mw=4,100, Mw/Mn=1.73

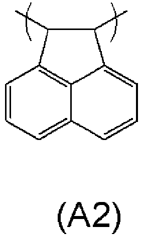

### [Synthesis Example 3] Synthesis of Polymer (A3)

Under a nitrogen atmosphere, 3.8 g of methanesulfonic acid and 30 g of methylene chloride were mixed together and homogenized at an internal temperature of 30°C. Subsequently, a mixed solution of 15.0 g of acenaphthylene, 11.5 g of indene, and 60.0 g of methylene chloride was added dropwise over 1 hour, and the mixture was heated and stirred at an internal temperature of 35°C for 24 hours. The resultant was cooled to room temperature, and then 300 g of toluene was added thereto. The resultant was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 25.3 g of a polymer (A3).

The weight-average molecular weight (Mw) and the dispersity (Mw/Mn) were determined by GPC, and the following results were obtained.
(A3): Mw=2,100, Mw/Mn=1.85

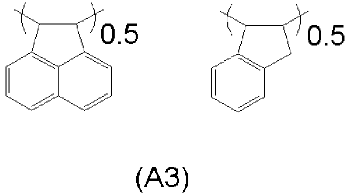

### [Synthesis Example 4] Synthesis of Polymer (A4)

Under a nitrogen atmosphere, 3.8 g of methanesulfonic acid and 31.6 g of methylene chloride were mixed together and homogenized at an internal temperature of 30°C. Subsequently, a mixed solution of 24.0 g of acenaphthylene, 7.6 g of 9-vinylcarbazole, and 63.2 g of methylene chloride was added dropwise over 1 hour, and the resultant was heated and stirred at an internal temperature of 35°C for 24 hours. The resultant was cooled to room temperature, and then 300 g of toluene was added thereto. The resultant was washed six times with 100 g of pure water, and the organic layer was evaporated under reduced pressure to dryness. After adding 95 g of THF to the residue to form a homogeneous solution, a crystal was precipitated in 630 g of methanol. The precipitated crystal was separated by filtration, washed twice with 300 g of methanol, and collected. The collected crystal was vacuum-dried at 70°C to obtain 30.1 g of a polymer (A4).

The weight-average molecular weight (Mw) and the dispersity (Mw/Mn) were determined by GPC, and the following results were obtained.
(A4): Mw=3,500, Mw/Mn=2.05

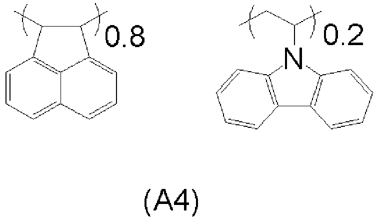

### [Synthesis Example 5] Synthesis of Polymer (A5)

37.5 g of propylene glycol monomethyl ether acetate (PGMEA) was heated and stirred under a nitrogen atmosphere at 80°C. A mixture of 38.0 g of acenaphthylene, 12.0 g of 9-vinylcarbazole, and 82.5 g of PGMEA and a mixture of 3.6 g of dimethyl 2,2-azobis(2-methylpropionate) and 30.0 g of PGMEA were added thereto simultaneously and separately over 2 hours. The obtained mixture was further heated and stirred for 24 hours, and then cooled to room temperature. The reaction solution was added dropwise to 750 g of methanol to precipitate a polymer. The precipitated crystal was separated by filtration, washed twice with 300 g of methanol, and collected. The collected crystal was vacuum-dried at 70°C to obtain 46.8 g of a polymer (A5).

The weight-average molecular weight (Mw) and the dispersity (Mw/Mn) were determined by GPC, and the following results were obtained.
(A5): Mw=4,800, Mw/Mn=2.23

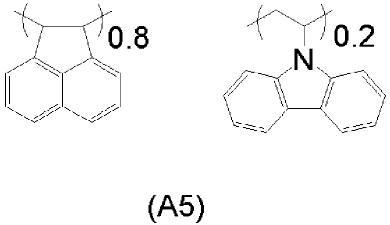

### [Synthesis Example 6] Synthesis of Polymer (A6)

Under a nitrogen atmosphere, 5.7 g of methanesulfonic acid and 29.5 g of methylene chloride were mixed together and homogenized at an internal temperature of 30°C. Subsequently, a mixed solution of 15.0 g of acenaphthylene, 6.9 g of indene, 7.6 g of 9-vinylcarbazole, and 59.0 g of methylene chloride was added dropwise over 1 hour, and the mixture was heated and stirred at an internal temperature of 35°C for 24 hours. The resultant was cooled to room temperature, and then 300 g of toluene was added thereto. The resultant was washed six times with 100 g of pure water, and the organic layer was evaporated under reduced pressure to dryness. After adding 90 g of THF to the residue to yield a homogeneous solution, a crystal was precipitated in 600 g of methanol. The precipitated crystal was separated by filtration, washed twice with 300 g of methanol, and collected. The collected crystal was vacuum-dried at 70°C to obtain 27.9 g of a polymer (A6).

The weight-average molecular weight (Mw) and the dispersity (Mw/Mn) were determined by GPC, and the following results were obtained.
(A6): Mw=4,000, Mw/Mn=2.15

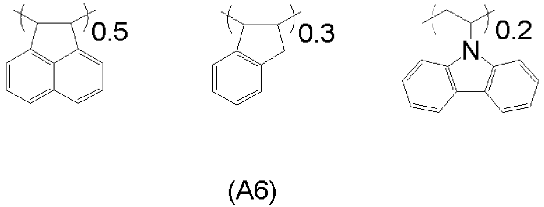

### Synthesis Examples: Synthesis of Crosslinking Agent (B)

### [Synthesis Example 7] Synthesis of Crosslinking Agent (B1)

Under an N₂ atmosphere, 500 mL of a 2.67 M hexane solution of n-butyllithium was added to a mixed solution of 219 g of bis(4-bromophenyl) ether and 1,000 mL of t-butylmethyl ether, which had been cooled to -20°C, and the mixture was stirred at -20°C for 20 minutes. 229 g of 9-fluorenone was added, the temperature was gradually raised to room temperature, and the obtained mixture was stirred at room temperature for 4 hours. Water was added to terminate the reaction. The resultant was washed with water and concentrated under reduced pressure. Subsequently, hexane was added, and the generated solid was collected by filtration, washed with hexane, and dried under reduced pressure to obtain 293 g of a crosslinking agent (B1).

The weight-average molecular weight (Mw) and the dispersity (Mw/Mn) were determined by GPC, and the following results were obtained.
(B1): Mw=540, Mw/Mn=1.02

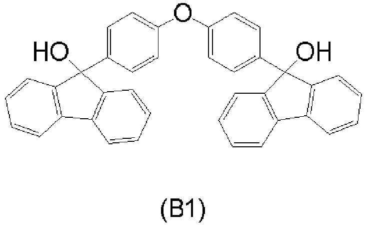

### [Synthesis Example 8] Synthesis of Crosslinking Agent (B2)

Under a nitrogen atmosphere, 168 g (0.54 mol) of 4,4'-dibromobiphenyl and 23.0 g (0.54 mol) of lithium chloride, which had been dissolved in 1,000 ml of dehydrated THF (tetrahydrofuran) beforehand, were added to a 5-L four-necked flask, 26.4 g (1.09 mol) of magnesium having been weighed and placed in the flask, to a level to immerse the magnesium. A small amount of dibromoethane was added to initiate a reaction, and then, while maintaining the generation of heat, the rest of the THF solution was added dropwise over 3 hours. After the addition had been completed, 500 ml of THF was added, and the resultant was aged under reflux for 8 hours to prepare a Grignard reagent. After cooling the resultant to an internal temperature of 55°C, 150 g (0.83 mol) of 9-fluorenone, which had been dissolved in 400 ml of dehydrated THF beforehand, was added dropwise over 2 hours. After completion of the addition, the resultant was aged under reflux for 5 and a half hours, the flask was cooled in an ice bath, and the reaction was quenched with 1,000 ml of a saturated aqueous ammonium chloride solution and 1,000 ml of pure water. In this event, a white precipitate formed in the solution, and a suspension was obtained. To the reaction solution, 150 ml of MIBK (methyl isobutyl ketone) was added, the suspension was transferred to a separating funnel in the state of a suspension, and the water layer was removed. Furthermore, liquid-liquid separation washing was performed with 500 ml of pure water, and then the organic layer was concentrated under reduced pressure. Recrystallization was performed with diisopropyl ether, the generated white crystal was obtained by filtering, and dried to obtain 109 g of a crosslinking agent (B2).

The weight-average molecular weight (Mw) and the dispersity (Mw/Mn) were determined by GPC, and the following results were obtained.
(B2): Mw=530, Mw/Mn=1.02

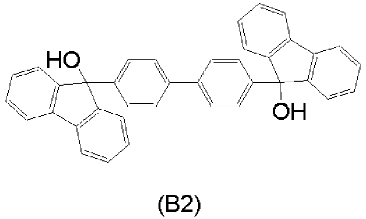

### [Synthesis Example 9] Synthesis of Crosslinking Agent (B3)

A suspension of 30.0 g of the crosslinking agent (B1) and 172.8 g of 1-butanol was formed under a nitrogen atmosphere at an internal temperature of 80°C. 16.8 g of methanesulfonic acid was added slowly, and a reaction was allowed to take place at an internal temperature of 100°C for 6 hours. The resultant was cooled in an ice bath to precipitate a crystal. The precipitated crystal was then separated by filtration, washed twice with 200 g of butanol, washed three times with 200 g of diisopropyl ether, and collected. The collected crystal was vacuum-dried at 60°C to obtain 34.2 g of a crosslinking agent (B3).

The weight-average molecular weight (Mw) and the dispersity (Mw/Mn) were determined by GPC, and the following results were obtained.
(B3): Mw=640, Mw/Mn=1.01

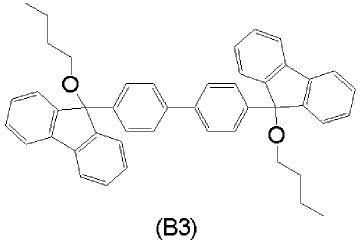

### Comparative Synthesis Examples: Synthesis of Comparative Polymer

In the syntheses of comparative polymers (R1) and (R2), the compound group G ((G1) to (G3)) shown below was used.

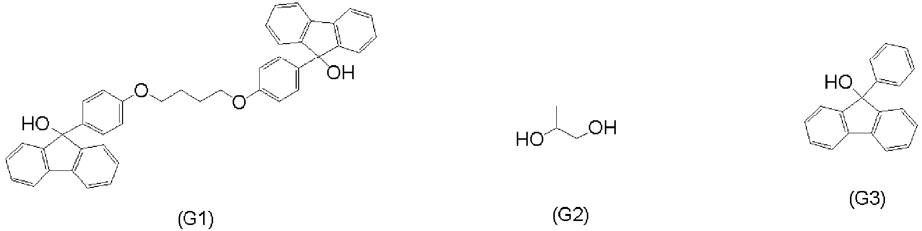

### [Comparative Synthesis Example 1] Synthesis of Comparative Polymer (R1)

The polymer reported in [Synthesis Example 1] of JP2021-084974A was synthesized. Under a nitrogen atmosphere, a suspension with an inner temperature of 60°C was prepared from 50.0 g of the compound (G1), 31.6 g of the compound (G2), and 300 g of 1,2-dichloroethane. Then, 8 ml of methanesulfonic acid was slowly added thereto. After confirming that the heat generation had ended, the reaction was allowed to proceed with the inner temperature of 60°C for 6 hours. After cooling to room temperature, 500 ml of methyl isobutyl ketone was added to the resultant, and the organic layer was washed six times with 100 g of pure water. Subsequently, the organic layer was dried under reduced pressure. To the residue, 150 g of tetrahydrofuran (THF) was added to form a homogeneous solution. Thereafter, the polymer was reprecipitated with 1,000 g of hexane. The precipitated polymer was separated by filtration, washed twice with 300 g of hexane, and collected. The collected polymer was vacuum-dried at 50°C. Thus, a comparative polymer (R1) was obtained.

The weight-average molecular weight (Mw) and the dispersity (Mw/Mn) were determined by GPC, and the following results were obtained.
(R1): Mw=2,120, Mw/Mn=1.83

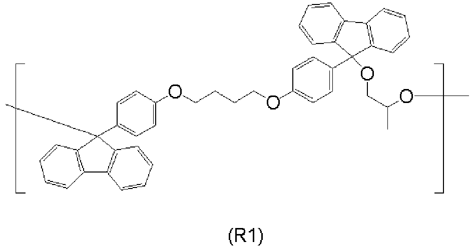

### [Comparative Synthesis Example 2] Synthesis of Comparative Polymer (R2)

The polymer reported in [Synthesis Example 1] of JP2021-138851A was synthesized. 54.5 g of fluorenol (G3) and 200 g of 1,2-dichloroethane were mixed and the temperature was raised to 50°C. 20.3 g of methanesulfonic acid was slowly added dropwise, and the mixture was heated and stirred at 70°C for 6 hours. After cooling to room temperature, 650 g of toluene was added, the resultant was washed six times with 100 g of pure water, and the organic layer was evaporated under reduced pressure to dryness. To the residue, 200 g of THF was added to form a homogeneous solution. Thereafter, a crystal was precipitated in 600 g of methanol. The precipitated crystal was separated by filtration, washed twice with 200 g of methanol, and collected. The collected crystal was vacuum-dried at 70°C. Thus, 60.7 g of a comparative polymer (R2) was obtained.

The weight-average molecular weight (Mw) and the dispersity (Mw/Mn) were determined by GPC, and the following results were obtained.
(R2): Mw=2,700, Mw/Mn=1.39

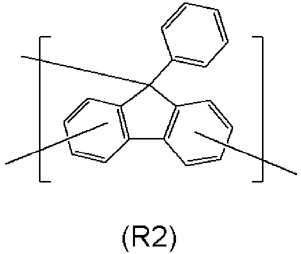

### [Comparative Synthesis Example 3] Synthesis of Comparative Polymer (R3)

In a 200-mL flask, 15.2 g of acenaphthylene, 3.3 g of 4-hydroxystyrene, and as a solvent, 60 g of 1,2-dichloroethane were placed. As a polymerization initiator, 1 g of boron trifluoride was added, and after raising the temperature to 60°C, a reaction was allowed to take place for 25 hours. To the reaction solution, 1 L of methanol and 500 g of water was added to precipitate a polymer. The obtained white solid was collected by filtration and then dried to obtain 12 g of a comparative polymer (R3).

The weight-average molecular weight (Mw) and the dispersity (Mw/Mn) were determined by GPC, and the following results were obtained.
(R3): Mw=8,800, Mw/Mn=1.82

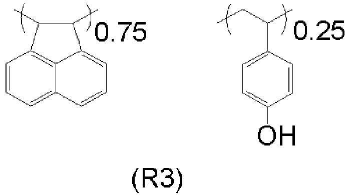

### [Comparative Synthesis Example 4] Synthesis of Comparative Polymer (R4)

Under a nitrogen atmosphere, 5.0 g of methanesulfonic acid and 30.0 g of methylene chloride were mixed together and homogenized at an internal temperature of 30°C. Subsequently, a mixed solution of 30.0 g of indene and 60.0 g of methylene chloride was added dropwise over 1 hour, and the resultant was heated and stirred at an internal temperature of 35°C for 24 hours. After cooling to room temperature, 300 g of toluene was added. The resultant was washed six times with 100 g of pure water, and the organic layer was evaporated under reduced pressure to dryness. To the residue, 90 g of THF was added to form a homogeneous solution. Thereafter, a crystal was precipitated in 600 g of methanol. The precipitated crystal was separated by filtration, washed twice with 300 g of methanol, and collected. The collected crystal was vacuum-dried at 70°C to obtain 26.9 g of a comparative polymer (R4).

The weight-average molecular weight (Mw) and the dispersity (Mw/Mn) were determined by GPC, and the following results were obtained.
(R4): Mw=2,500, Mw/Mn=1.83

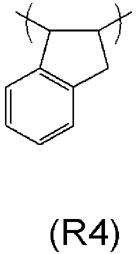

### [Comparative Synthesis Example 5] Synthesis of Comparative Polymer (R5)

Under a nitrogen atmosphere, 1.9 g of methanesulfonic acid and 30.0 g of methylene chloride were mixed together and homogenized at an internal temperature of 30°C. Subsequently, a mixed solution of 30.0 g of 9-vinylcarbazole and 60.0 g methylene chloride was added dropwise over 1 hour, and the resultant was heated and stirred at an internal temperature of 35°C for 24 hours. The resultant was cooled to room temperature, and then 300 g of toluene was added thereto. The resultant was washed six times with 100 g of pure water, and the organic layer was evaporated under reduced pressure to dryness. After adding 90 g of THF to the residue to form a homogeneous solution, a crystal was precipitated in 600 g of methanol. The precipitated crystal was separated by filtration, washed twice with 300 g of methanol, and collected. The collected crystal was vacuum-dried at 70°C to obtain 29.3 g of a comparative polymer (R5).

The weight-average molecular weight (Mw) and the dispersity (Mw/Mn) were determined by GPC, and the following results were obtained.
(R5): Mw=3,800, Mw/Mn=2.18

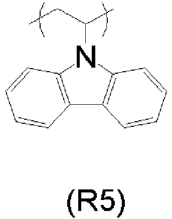

### [Composition UDL-1 for Forming Resist Underlayer Film]

The polymer (A1), the crosslinking agent (B1), and a flowability accelerator (D-1) described later as an additive were dissolved at a ratio shown in Table 2 in a mixed solvent of propylene glycol monomethyl ether acetate (PGMEA) and cyclohexanone (CyHO) containing 0.5 mass% of a surfactant FC-4430 (manufactured by Sumitomo 3M Limited), and the solution was filtered through a 0.02-µm membrane filter to prepare a composition (UDL-1) for forming a resist underlayer film.

### [Preparation of Compositions (UDL-2 to -10) for Forming Resist Underlayer Film and Compositions (Comparative UDL-1 to -7) for Forming Resist Underlayer Film for Comparative Examples]

Each composition was prepared in the same manner as UDL-1, except that the kind and the contained amount of each component were as shown in Table 2. In Table 2, "-" indicates that the component was not used. The following formula (F-1) was used for the acid generator (TAG), the following formula (D-1) was used for the flowability accelerator, and the following formula (XL-1) was used for the comparative crosslinking agent.

### [Acid Generator]

The acid generator (F-1) used in compositions for forming a resist underlayer film is shown below.

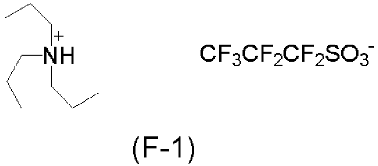

### [Flowability Accelerator]

The flowability accelerator (D-1) used in a composition for forming a resist underlayer film is shown in Table 1.

**[Table 1]**

| Compound | Mw (calculated value) | Weight reduction rate (%) at 30°C to 190°C | Weight reduction rate (%) at 30°C to 350°C |
|---|---|---|---|
| 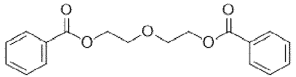 (D-1) | 314 | 1 | 100 |

### [Comparative Crosslinking Agent]

The comparative crosslinking agent (XL-1) used in comparative UDL-5 is shown below.

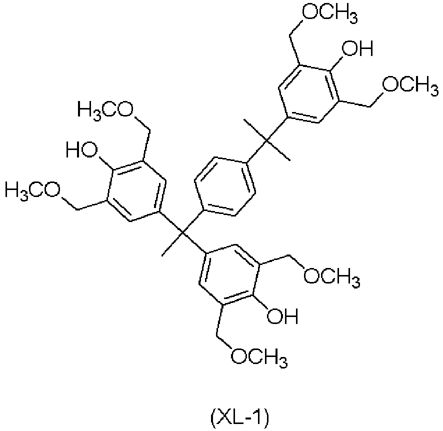

**[Table 2]**

| Composition for forming resist underlayer film | Polymer | Crosslinking agent | Additive | Solvent |
|---|---|---|---|---|
| | (part by mass) | (part by mass) | (part by mass) | (part by mass) |
| UDL-1 | A1 (12) | B1 (3) | F-1 (0.2) | PGMEA/CyHO (50/35) |
| UDL-2 | A2 (12) | B1 (3) | F-1 (0.2) | PGMEA/CyHO (50/35) |
| UDL-3 | A3 (12) | B1 (3) | F-1 (0.2) | PGMEA/CyHO (50/35) |
| UDL-4 | A4 (12) | B1 (3) | F-1 (0.2) | PGMEA/CyHO (50/35) |
| UDL-5 | A5 (12) | B1 (3) | F-1 (0.2) | PGMEA/CyHO (50/35) |
| UDL-6 | A6 (12) | B1 (3) | F-1 (0.2) | PGMEA/CyHO (50/35) |
| UDL-7 | A1(6), R4(4), R5 (2) | B1 (3) | F-1 (0.2) | PGMEA/CyHO (50/35) |
| UDL-8 | A1 (10) | B2 (5) | F-1 (0.2) | PGMEA/CyHO (50/35) |
| UDL-9 | A1 (13.5) | B3 (1.5) | F-1 (0.2) | PGMEA/CyHO (50/35) |
| UDL-10 | A1 (12) | B2 (3) | F-1 (0.2) D-1 (6) | PGMEA/CyHO (50/35) |
| Comparative UDL-1 | R1(12) | B1 (3) | F-1 (0.2) | PGMEA/CyHO (50/35) |
| Comparative UDL-2 | R2 (12) | B1 (3) | F-1 (0.2) | PGMEA/CyHO (50/35) |
| Comparative UDL-3 | R3 (12) | B1 (3) | F-1 (0.2) | PGMEA/CyHO (50/35) |
| Comparative UDL-4 | A1 (12) | - | F-1 (0.2) | PGMEA/CyHO (50/35) |
| Comparative UDL-5 | A1 (12) | XL-1 (3) | F-1 (0.2) | PGMEA/CyHO (50/35) |
| Comparative UDL-6 | R4 (12) | B1 (3) | F-1 (0.2) | PGMEA/CyHO (50/35) |
| Comparative UDL-7 | R5 (12) | B1 (3) | F-1 (0.2) | PGMEA/CyHO (50/35) |

### [Solvent Resistance Evaluation and Film Thickness Uniformity Evaluation (Examples 1-1 to 1-10 and Comparative Examples 1-1 to 1-7)]

Each of the compositions (UDL-1 to -10 and comparative UDL-1 to -7) for forming a resist underlayer film prepared as described above was respectively applied onto a silicon substrate and baked at 350°C for 60 seconds. After that, the film thickness from the central portion to the peripheral portion of the substrate was measured and the average film thickness (a [nm]) was calculated. Subsequently, a PGMEA solvent was dispensed thereon, and the resultant was left to stand for 30 seconds, spin-dried, and baked at 100°C for 60 seconds to evaporate the PGMEA. The film thickness (b [nm]) was then measured. The difference between the film thicknesses (film remaining percentage: (b/a) × 100) before and after the PGMEA treatment was determined.

In addition, regarding the films baked at 350°C for 60 seconds, the film thickness from the central portion of the substrate to the peripheral portion was measured. When the difference between the maximum film thickness and the minimum film thickness was less than 5% of the average film thickness (a), the evaluation "Good" was given, and when 5% or more, the evaluation "Poor" was given.

The results are shown below in Table 3.

**[Table 3]**

| Example | Composition for forming resist underlayer film | Film thickness (a) | After PGMEA treatment (b) | Film remaining percentage | Film thickness uniformity |
|---|---|---|---|---|---|
| | | nm | nm | b/a × 100 (%) | - |
| Example 1-1 | UDL-1 | 100.9 | 100.8 | 100% | Good |
| Example 1-2 | UDL-2 | 103.4 | 103.4 | 100% | Good |
| Example 1-3 | UDL-3 | 101.4 | 101.4 | 100% | Good |
| Example 1-4 | UDL-4 | 103.2 | 103.1 | 100% | Good |
| Example 1-5 | UDL-5 | 104.7 | 104.7 | 100% | Good |
| Example 1-6 | UDL-6 | 100.1 | 100 | 100% | Good |
| Example 1-7 | UDL-7 | 102.6 | 102.5 | 100% | Good |
| Example 1-8 | UDL-8 | 101.5 | 101.6 | 100% | Good |
| Example 1-9 | UDL-9 | 101.7 | 101.7 | 100% | Good |
| Example 1-10 | UDL-10 | 85.7 | 85.6 | 100% | Good |
| Comparative Example 1-1 | Comparative UDL-1 | 116.4 | 116.4 | 100% | Good |
| Comparative Example 1-2 | Comparative UDL-2 | 113.6 | 113.5 | 100% | Good |
| Comparative Example 1-3 | Comparative UDL-3 | 104.7 | 104.7 | 100% | Good |
| Comparative Example 1-4 | Comparative UDL-4 | 83.7 | 82.4 | 98% | Poor |
| Comparative Example 1-5 | Comparative UDL-5 | 98.6 | 98.6 | 100% | Good |
| Comparative Example 1-6 | Comparative UDL-6 | 64.7 | 64.7 | 100% | Poor |
| Comparative Example 1-7 | Comparative UDL-7 | 73.7 | 73.8 | 100% | Poor |

As shown in Table 3, in Examples 1-1 to 1-10, where the inventive compositions (UDL-1 to -10) for forming a resist underlayer film were used, the film remaining percentage ((b/a) × 100) after the PGMEA rinsing was more than 99%, and it can be seen that a crosslinking reaction took place and sufficient solvent resistance was exhibited. On the other hand, in Comparative Example 1-4, where comparative UDL-4, containing no crosslinking agents, was used, solvent resistance was less than 99%, possibly because thermosetting property was insufficient.

Meanwhile, in Examples 1-1 to 1-10, where the inventive compositions (UDL-1 to -10) for forming a resist underlayer film were used, the difference between the maximum film thickness and the minimum film thickness of the film that had been baked at 350°C was less than 5% of the average film thickness (a), and it was shown that film thickness uniformity was good. On the other hand, in Comparative Example 1-4, Comparative Example 1-6, and Comparative Example 1-7, where comparative UDL-4, containing no crosslinking agents, and comparative UDL-6 and -7, containing polymers different from the present invention, were used, the difference between the maximum film thickness and the minimum film thickness of the film that had been baked at 350°C was 5% or more of the average film thickness (a). Thus, it was shown that film thickness uniformity was insufficient. Regarding comparative UDL-4, it is conjectured that this is because the thermosetting property of the polymer was insufficient since no crosslinking agents were contained, and thus, a large amount of uncured components of the polymer sublimed during the baking at 350°C. Regarding comparative UDL-6 and -7, it is conjectured that the above is because the heat resistance of the polymer was considerably low and thermal decomposition progressed drastically during the baking at 350°C.

### [Filling Property and Flatness Evaluation (Examples 2-1 to 2-10 and Comparative Examples 2-1 to 2-6)]

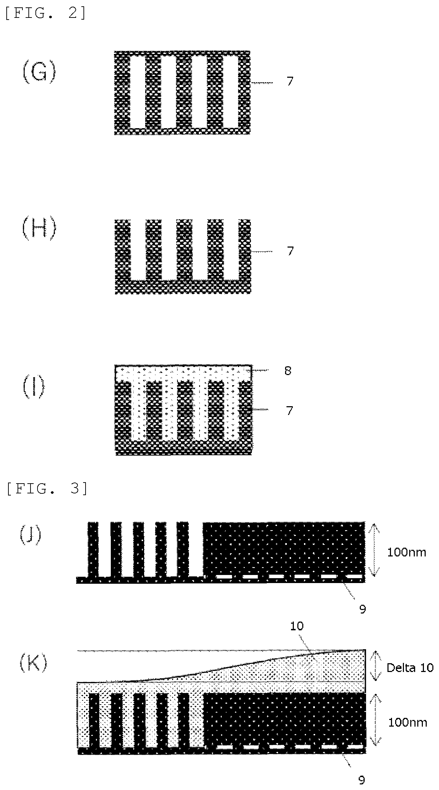

Filling property evaluation: each of the compositions (UDL-1 to -10 and comparative UDL-1 to -3 and -5 to -7) for forming a resist underlayer film that were favorable in the solvent resistance evaluation was respectively applied onto an SiO₂ wafer substrate having a dense line-and-space pattern (line width = 60 nm, line depth = 100 nm, distance between the centers of two adjacent lines = 120 nm), followed by heating at 350°C for 60 seconds by using a hot plate to form a resist underlayer film having a film thickness of 100 nm. The substrate used was a base substrate 7 (SiO₂ wafer substrate) having a dense line-and-space pattern shown in FIG. 2(G) (downward view) and (H) (cross-sectional view).

The cross-sectional shape of each of the obtained wafer substrates was observed using an electron microscope (S-4700: manufactured by Hitachi, Ltd.), and the presence/absence of voids (gaps) inside the resist underlayer film filling the space between the lines was confirmed. Table 4 shows the results. In this evaluation, when a composition for forming a resist underlayer film having a poor filling property is used, voids are generated inside the resist underlayer film filling the space between the lines. In this evaluation, when a composition for forming a resist underlayer film having a desirable filling property is used, as shown in FIG. 2(I), the inside of the resist underlayer film filling the space between the lines of the base substrate 7 having the dense line-and-space pattern is filled with a void-free resist underlayer film 8.

Flatness evaluation: regarding base substrates 9 (SiO₂ wafer substrates) each having a dense line-and-space pattern shown in FIG. 3(J), the cross sectional shape of each of the wafer substrates obtained in the filling property evaluation as shown in FIG. 3(K) was observed using a scanning electron microscope (SEM), and the step Delta 10 between the line-pattern-dense portion and the non-line-pattern portion of the resist underlayer film 10 was observed using an electron microscope (S-4700: manufactured by Hitachi, Ltd.). In the present evaluation, it can be said that the smaller the step, the better the planarizing property.

Table 4 shows the results.

**[Table 4]**

| Example | Composition for forming resist underlayer film | Filling property | Flatness |
|---|---|---|---|
| | | Voids | nm |
| Example 2-1 | UDL-1 | Absent | 48 |
| Example 2-2 | UDL-2 | Absent | 49 |
| Example 2-3 | UDL-3 | Absent | 45 |
| Example 2-4 | UDL-4 | Absent | 46 |
| Example 2-5 | UDL-5 | Absent | 48 |
| Example 2-6 | UDL-6 | Absent | 42 |
| Example 2-7 | UDL-7 | Absent | 42 |
| Example 2-8 | UDL-8 | Absent | 49 |
| Example 2-9 | UDL-9 | Absent | 47 |
| Example 2-10 | UDL-10 | Absent | 44 |
| Comparative Example 2-1 | Comparative UDL-1 | Absent | 53 |
| Comparative Example 2-2 | Comparative UDL-2 | Absent | 55 |
| Comparative Example 2-3 | Comparative UDL-3 | Absent | 45 |
| Comparative Example 2-4 | Comparative UDL-5 | Absent | 47 |
| Comparative Example 2-5 | Comparative UDL-6 | Absent | 43 |
| Comparative Example 2-6 | Comparative UDL-7 | Absent | 42 |

As shown in Table 4, it was successfully confirmed that in Examples 2-1 to 2-10 using the inventive compositions (UDL-1 to -10) for forming a resist underlayer film, it was possible to fill the dense line-and-space pattern without the generation of voids, and excellent filling property was provided. Furthermore, it was observed that the step in the film between the patterned portion and the non-patterned portion was smaller and planarizing property was better than in Comparative Example 2-1 and Comparative Example 2-2, using comparative polymers R1 and R2, which were reported in JP2021-084974A and JP2021-138851A as polymers having excellent resistance to dry etching during substrate processing.

Comparing Examples 2-1 to 2-4, UDL-3 and UDL-4, in which the polymer had a structure of the general formula (1A) and a structure of the general formulae (1B), were used in Example 2-3 and Example 2-4, and better flatness was achieved in Example 2-3 and Example 2-4. This is thought to be because thermal flowability was enhanced by the structure of the general formulae (1B) being incorporated.

Meanwhile, comparing Example 2-8 and Example 2-10, better flatness was achieved in Example 2-10. This is thought to be because thermal flowability was enhanced by the flowability accelerator (D-1) being contained.

### [Etching Resistance Evaluation (Examples 3-1 to 3-10 and Comparative Examples 3-1 to 3-6)]

Each of the compositions (UDL-1 to -10 and comparative UDL-1 to -3 and -5 to -7) for forming a resist underlayer film, which had favorable solvent resistance evaluation in the above, was respectively applied onto a silicon substrate and heated by using a hot plate at 350°C for 60 seconds to form a resist underlayer film, and the film thickness "a" was measured. Subsequently, etching was performed with CF₄ gas under the following conditions by using an etching apparatus Telius manufactured by Tokyo Electron Ltd., and the film thickness "b" was measured. Then, the film thickness etched in 1 minute was calculated as an etching rate A (nm/min) from the film thickness etched (film thickness "a" - film thickness "b") by the CF₄ gas in a specified time. In addition, separately from the above, a substrate heated at 350°C for 60 seconds was fabricated and heated at 500°C for 90 seconds under a nitrogen stream in which the oxygen concentration was controlled to 0.2% or less to form a resist underlayer film. Then, the film thickness "c" was measured. Subsequently, etching was performed with CF₄ gas under the following conditions by using an etching apparatus Telius manufactured by Tokyo Electron Ltd., and the film thickness "d" was measured. Then, the film thickness etched in 1 minute was calculated as an etching rate B (nm/min) from the film thickness etched (film thickness "c" - film thickness "d") by the CF₄ gas in a specified time. A smaller value of the etching rate indicates that the composition has better resistance to etching with the CF₄ gas.

The etching resistance of the films baked at 500°C and that of the films baked at 350°C were compared, and the effect of the 500°C-baking on the improvement of etching resistance (etching rate A (nm/min) - etching rate B (nm/min)) was calculated.

The etching conditions were as shown below.

### Conditions of dry etching with CF₄ gas

Chamber pressure: 50 mT
RF-power (upper portion): 500 W
RF-power (lower portion): 300 W
CF₄ gas flow rate: 150 sccm
CHF₃ gas flow rate: 50 sccm
Time: 30 sec

**[Table 5]**

| Example | Composition for forming resist underlayer film | CF₄ etching rate A (nm/min) | CF₄ etching rate B (nm/min) | Improvement effect |
|---|---|---|---|---|
| | | 350°C | 350°C + 500°C | nm/min |
| Example 3-1 | UDL-1 | 65 | 57 | 8 |
| Example 3-2 | UDL-2 | 67 | 60 | 7 |
| Example 3-3 | UDL-3 | 67 | 60 | 7 |
| Example 3-4 | UDL-4 | 68 | 61 | 7 |
| Example 3-5 | UDL-5 | 70 | 63 | 7 |
| Example 3-6 | UDL-6 | 68 | 60 | 8 |
| Example 3-7 | UDL-7 | 68 | 61 | 7 |
| Example 3-8 | UDL-8 | 68 | 60 | 8 |
| Example 3-9 | UDL-9 | 66 | 58 | 8 |
| Example 3-10 | UDL-10 | 67 | 59 | 8 |
| Comparative Example 3-1 | Comparative UDL-1 | 85 | 82 | 3 |
| Comparative Example 3-2 | Comparative UDL-2 | 69 | 67 | 2 |
| Comparative Example 3-3 | Comparative UDL-3 | 74 | 71 | 3 |
| Comparative Example 3-4 | Comparative UDL-5 | 77 | 74 | 3 |
| Comparative Example 3-5 | Comparative UDL-6 | 75 | 72 | 3 |
| Comparative Example 3-6 | Comparative UDL-7 | 83 | 80 | 3 |

As shown in Table 5, it was shown that the etching rate of the 350°C-baked films using the CF₄ gas was 70 nm/min or less in Examples 3-1 to 3-10, where the inventive compositions (UDL-1 to -10) for forming a resist underlayer film were used, and that the compositions exhibited excellent etching resistance. Furthermore, the etching resistance of the films baked at 500°C under a nitrogen stream in which the oxygen concentration was controlled to 0.2% or less was even better, and an improvement in etching rate of more than 5 nm/min from the 350°C-baked films was observed. This is conjectured to be because the inventive compositions for forming a resist underlayer film were high-carbon materials that actively undergo thermal decomposition of the cured film due to high-temperature baking, and therefore, when the compositions were baked at 500°C under a nitrogen stream in which the oxygen concentration was controlled to 0.2% or less, decomposition and recombination of carbon bonds occurred, and the cured film became dense.

Comparing UDL-1, in which the polymer (A1), synthesized by cationic polymerization, was used, and UDL-2, in which the polymer (A2), synthesized by radical polymerization, was used, UDL-1 achieved better etching resistance results. This is conjectured to be because in radical polymerization, to the polymer is introduced a terminal structure containing heteroatoms, such as oxygen and nitrogen, other than carbon, originating from the radical initiator, which degrade etching resistance, but in cationic polymerization, there is no such inconvenience.

Polymers having a fluorene skeleton are known as materials having excellent etching resistance in substrate processing, but in Comparative Example 3-1, using the comparative polymer R1, the film baked at 350°C had insufficient etching resistance. It is conjectured that the ether chain in the polymer had an effect on the degradation of the etching resistance. WO2014/066268A2 reports a combination of the crosslinking agent contained in the inventive composition for forming a resist underlayer film and a polyether. This invention is for a purpose different from resist underlayer films, but if this composition was used for a resist underlayer film, it is assumed that etching resistance would be insufficient for the same reason as Comparative Example 3-1. Meanwhile, it is conjectured that the etching resistance of comparative UDL-3, containing comparative polymer R3, was degraded compared to UDL-1, since comparative UDL-3 contained a polymer having hydroxy groups. For the above reasons, it is necessary for the inventive composition for forming a resist underlayer film to contain no oxygen atoms, which degrade etching resistance, in the polymer.

Meanwhile, in Comparative Example 3-2, using comparative polymer R2, which is reported in JP2021-138851A as a polymer having excellent dry etching resistance in substrate processing, no oxygen atoms to degrade etching resistance were contained, and therefore, the 350°C-baked film exhibited excellent etching resistance, but little improvement effect was achieved on the baking at 500°C. This is conjectured to be because comparative UDL-2 had excellent heat resistance, unlike the inventive compositions for forming a resist underlayer film, and therefore, the densification of the cured film was not promoted in the baking at 500°C.

In Comparative Examples 3-4 to 3-6, using comparative UDL-5, in which the crosslinking agent was changed to XL-1, or using comparative UDL-6 to -7, in which only the polymers having the structure represented by the general formulae (1B) (comparative polymers R4 and R5) were used as polymers, the etching resistance at the time of the baking at 350°C was insufficient, and the improvement effect on baking at 500°C was also small. It is conjectured that, although comparative polymers R4 and R5 are also polymers that actively undergo thermal decomposition due to high-temperature baking, the sublimation of low molecular weight components due to thermal decomposition was dominant, and it was harder for the densification of the cured film to progress than the polymer (A1).

In other words, in order to form a resist underlayer film having excellent etching resistance, the combination of the polymer having the structure represented by the general formula (1A) and the crosslinking agent represented by the general formula (B-1) is necessary.

### [Patterning Process (Examples 4-1 to 4-10 and Comparative Examples 4-1 to 4-6)]

Each of the compositions (UDL-1 to -10, comparative UDL-1 to -3, and comparative UDL-5 to -7) for forming a resist underlayer film was respectively applied onto a silicon wafer substrate on which an SiO₂ film having a trench pattern (trench width: 10 µm, trench depth: 0.10 µm) was formed, and baked at 350°C for 60 seconds in the atmosphere. After that, the resultant was heated at 500°C for 90 seconds under a nitrogen stream in which the oxygen concentration was controlled to 0.2% or less to form a resist underlayer film having a thickness of 100 nm. A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 6; and filtering the solution through a filter made of a fluororesin and having a pore size of 0.1 µm.

**[Table 6]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

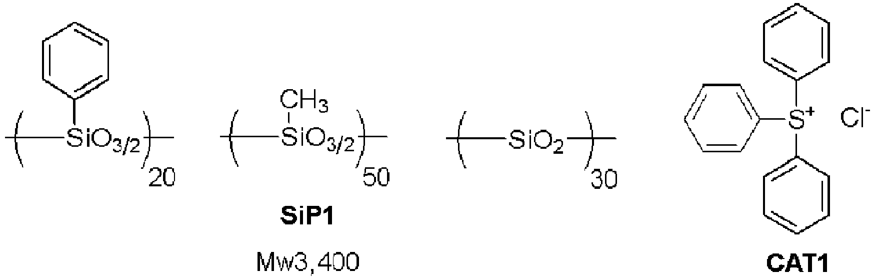

The resist upper layer film material (monolayer resist for ArF) was prepared by dissolving a polymer (RP1), an acid generator (PAG1), and a basic compound (Amine1), each in the proportion shown in Table 7, in a solvent containing 0.1% by mass of a surfactant (FC-4430: manufactured by Sumitomo 3M Limited), and filtering the solution through a 0.1-µm filter made of a fluororesin.

**[Table 7]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

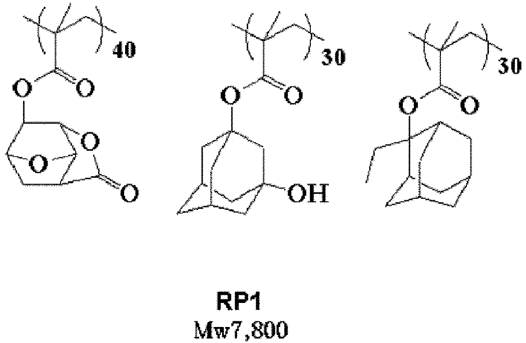

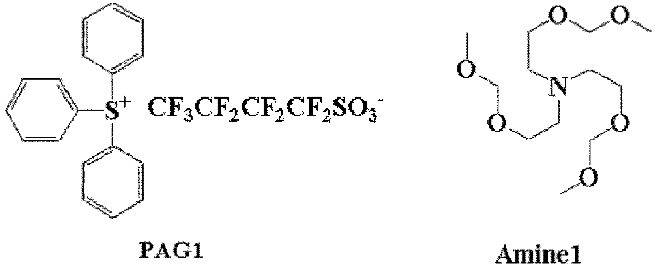

The liquid immersion top coat composition (TC-1) was prepared by dissolving a top coat polymer (PP1) in an organic solvent at the proportion shown in Table 8, and filtering the solution through a 0.1-µm filter made of a fluororesin.

**[Table 8]**

| | Top coat polymer (parts by mass) | Organic solvent (parts by mass) |
|---|---|---|
| TC-1 | PP1 (100) | Diisoamyl ether (2,700) |
| | | 2-methyl-1-butanol (270) |

The top coat polymer (PP1) used for the liquid immersion top coat composition (TC-1) is shown below.

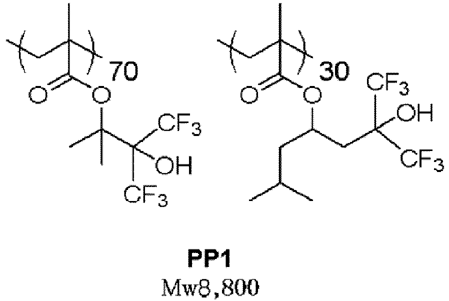

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching by using an etching apparatus Telius manufactured by Tokyo Electron Ltd. while using the resist upper layer film pattern as a mask to form a resist middle layer film pattern. The resist underlayer film was then etched while using the obtained resist middle layer film pattern as a mask to form a resist underlayer film pattern, and the SiO₂ film was etched while using the obtained resist underlayer film pattern as a mask. The etching conditions were as follows.

### Conditions in transferring resist upper layer film pattern to resist middle layer film

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring resist middle layer film pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 30 sec

### Conditions in transferring resist underlayer film pattern to SiO₂ film.

Chamber pressure: 10 mT
RF-power (upper portion): 100 W
RF-power (lower portion): 800 W
CF₄ gas flow rate: 25 sccm
CHF₃ gas flow rate: 15 sccm
O₂ gas flow rate: 5 sccm
Time: 100 sec

Table 9 shows the results obtained by observation of the pattern cross section with an electron microscope (S-4700) manufactured by Hitachi, Ltd.

**[Table 9]**

| Example | Composition for forming resist underlayer film | Pattern profile after etching for transferring to substrate | CD after substrate processing | LWR after substrate processing |
|---|---|---|---|---|
| | | | nm | nm |
| Example 4-1 | UDL-1 | Vertical profile | 50.8 | 2.86 |
| Example 4-2 | UDL-2 | Vertical profile | 50.9 | 2.94 |
| Example 4-3 | UDL-3 | Vertical profile | 50.5 | 2.87 |
| Example 4-4 | UDL-4 | Vertical profile | 50.6 | 2.88 |
| Example 4-5 | UDL-5 | Vertical profile | 50.7 | 2.93 |
| Example 4-6 | UDL-6 | Vertical profile | 50.4 | 2.94 |
| Example 4-7 | UDL-7 | Vertical profile | 50.5 | 2.92 |
| Example 4-8 | UDL-8 | Vertical profile | 50.7 | 2.86 |
| Example 4-9 | UDL-9 | Vertical profile | 50.8 | 2.85 |
| Example 4-10 | UDL-10 | Vertical profile | 50.8 | 2.86 |
| Comparative Example 4-1 | Comparative UDL-1 | Vertical profile | 48.6 | 3.25 |
| Comparative Example 4-2 | Comparative UDL-2 | Vertical profile | 49.7 | 3.15 |
| Comparative Example 4-3 | Comparative UDL-3 | Vertical profile | 47.9 | 3.17 |
| Comparative Example 4-4 | Comparative UDL-5 | Vertical profile | 49.4 | 3.19 |
| Comparative Example 4-5 | Comparative UDL-6 | Vertical profile | 49.5 | 3.18 |
| Comparative Example 4-6 | Comparative UDL-7 | Vertical profile | 48.7 | 3.21 |

As shown in Table 9, in Examples 4-1 to 4-10, using the inventive compositions (UDL-1 to -10) for forming a resist underlayer film, the resist upper layer film pattern was desirably transferred to the substrate in the end in every case. It was thus confirmed that the inventive composition for forming a resist underlayer film can be suitably used for fine processing using the multilayer resist method. In addition, the LWR after the substrate processing was also favorable. On the other hand, in Comparative Examples 4-1 to 4-6, using comparative UDL-1 to -3 and comparative UDL-5 to -7, which were found to have insufficient etching resistance compared to the inventive compositions for forming a resist underlayer film in the above-described etching resistance evaluation, the pattern profile after the etching to transfer the pattern to the substrate was a vertical profile, but degradation in LWR was observed after the substrate processing.

It was thus revealed that the inventive composition for forming a resist underlayer film has both high filling/planarizing properties and dry etching resistance, and therefore, is significantly useful as a resist underlayer film composition used in the multilayer resist method, and that the inventive patterning process using this composition is capable of forming fine patterns with a high degree of accuracy even when a body to be processed is a substrate having a step. It was also revealed that according to the inventive method for forming a resist underlayer film, a void-free resist underlayer film can be formed even when the body to be processed is a stepped substrate.

It should be noted that the present invention is not limited to the above-described embodiments. The embodiments are just examples, and any examples that have the same feature and demonstrate the same functions and effects as those in the technical concept disclosed in claims of the present invention are included in the technical scope of the present invention.

## Claims

1. A composition for forming a resist underlayer film, comprising: (A) a polymer having a structure represented by the following general formula (1A); (B) a crosslinking agent represented by the following general formula (B-1); and (C) an organic solvent, wherein the polymer (A) contains no hydroxy groups and the crosslinking agent (B) is contained in an amount of 5 to 50 parts by mass relative to 100 parts by mass of the polymer (A), 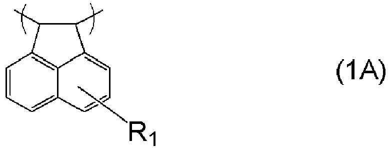
wherein R₁ represents a hydrogen atom, a halogen atom, or a linear, branched, or cyclic hydrocarbon group having 1 to 20 carbon atoms, 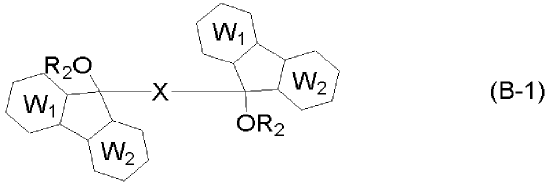
wherein W₁ and W₂ each independently represent a benzene ring or a naphthalene ring optionally having a substituent, each R₂ independently represents a hydrogen atom or a monovalent organic group having 1 to 20 carbon atoms, and X represents a group represented by one of the following formulae (2), 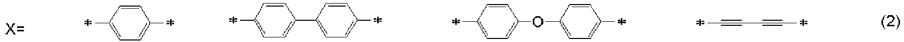
wherein "*" represents an attachment point.

2. The composition for forming a resist underlayer film according to claim 1, further comprising a polymer having partial structures represented by the following general formulae (1B), 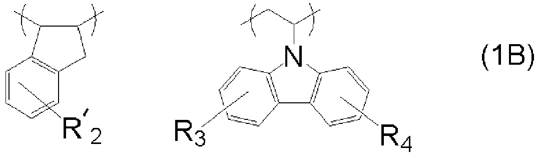 wherein R'₂, R₃, and R₄ each independently represent a hydrogen atom, a halogen atom, or a linear, branched, or cyclic hydrocarbon group having 1 to 20 carbon atoms.

3. The composition for forming a resist underlayer film according to claim 1 or 2, wherein the polymer (A) has structures represented by the following general formulae (1C), 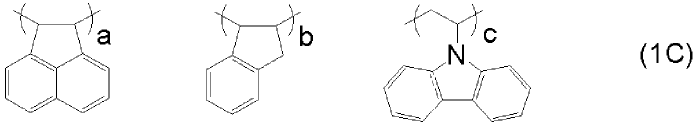 wherein "a", "b", and "c" satisfy a+b+c = 1, 0.5 ≤ a ≤ 0.9, and 0.1 ≤ b+c ≤ 0.5.

4. The composition for forming a resist underlayer film according to any one of claims 1 to 3, wherein the polymer (A) has a weight-average molecular weight Mw of 500 to 5,000 as measured by gel permeation chromatography in terms of polystyrene.

5. The composition for forming a resist underlayer film according to any one of claims 1 to 4, wherein the crosslinking agent (B) satisfies 1.00 ≤ Mw/Mn ≤ 1.25, where Mw is a weight-average molecular weight and Mn is a number-average molecular weight measured by gel permeation chromatography in terms of polystyrene.

6. The composition for forming a resist underlayer film according to any one of claims 1 to 5, comprising (D) a flowability accelerator having a weight reduction rate of less than 30% at 30°C to 190°C and a weight reduction rate of 98% or more at 30°C to 350°C.

7. The composition for forming a resist underlayer film according to claim 6, wherein the flowability accelerator (D) contains one or more compounds selected from the following general formulae (i) to (iii), 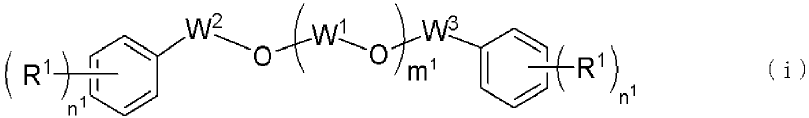
wherein each R¹ independently represents a hydrogen atom, a hydroxy group, or an optionally substituted organic group having 1 to 10 carbon atoms; W¹ represents a phenylene group, or a divalent group represented by the following general formula (i-1); W² and W³ each independently represent a single bond or a divalent group represented by one of the following formulae (i-2); "m¹" represents an integer of 1 to 10; and "n¹" represents an integer of 0 to 5, 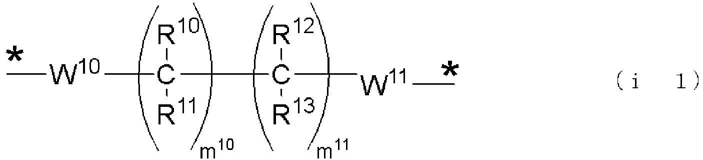
wherein "*" represents an attachment point; R¹⁰, R¹¹, R¹², and R¹³ each independently represent a hydrogen atom, a hydroxy group, or an organic group having 1 to 10 carbon atoms; W¹⁰ and W¹¹ each independently represent a single bond or a carbonyl group; and "m¹⁰" and "m¹¹" represent an integer of 0 to 10, provided that m¹⁰+m¹¹ ≥ 1, 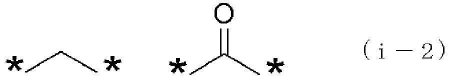
wherein "*" represents an attachment point, 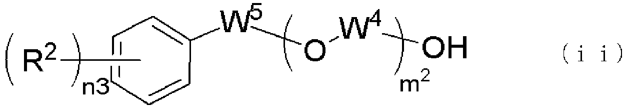
wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by one of the following formulae (ii-2); "m²" represents an integer of 2 to 10; and "n³" represents an integer of 0 to 5, 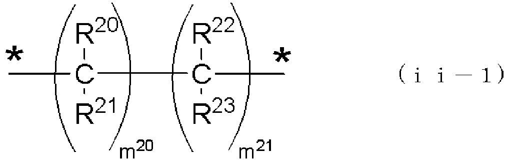
wherein "*" represents an attachment point; R²⁰, R²¹, R²¹, R²², and R²³ each independently represent a hydrogen atom, a hydroxy group, or an organic group having 1 to 10 carbon atoms; and "m²⁰" and "m²¹" represent an integer of 0 to 10, provided that m²⁰+m²¹ ≥ 1, 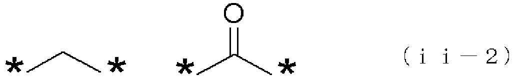
wherein "*" represents an attachment point, 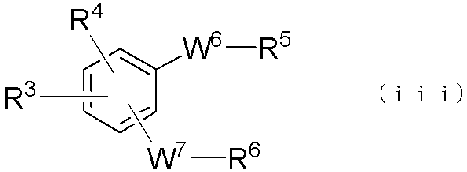
wherein R³ and R⁴ each independently represent a hydrogen atom, a hydroxy group, or an optionally substituted organic group having 1 to 10 carbon atoms and are optionally bonded to each other to form a cyclic structure; R⁵ and R⁶ each independently represent an organic group having 1 to 10 carbon atoms, R⁵ being a group containing an aromatic ring or a divalent group represented by the following general formula (iii-1); and W⁶ and W⁷ represent a single bond or a divalent group represented by one of the following formulae (iii-2), at least one of W⁶ and W⁷ being a divalent group represented by one of the following formulae (iii-2), 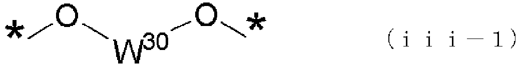
wherein "*" represents an attachment point; and W³⁰ represents an organic group having 1 to 4 carbon atoms, 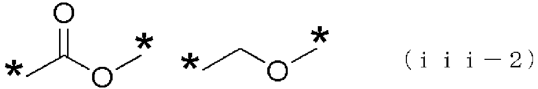
wherein "*" represents an attachment point.

8. The composition for forming a resist underlayer film according to any one of claims 1 to 7, further comprising one or more of (E) a surfactant, (F) an acid generator, and (G) a plasticizer.

9. A patterning process for forming a pattern in a substrate to be processed, comprising the steps of:
A)
(I-1) applying the composition for forming a resist underlayer film according to any one of claims 1 to 8 onto a substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed; or
B)
(II-1) applying the composition for forming a resist underlayer film according to any one of claims 1 to 8 onto a substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed; or
C)
(III-1) applying the composition for forming a resist underlayer film according to any one of claims 1 to 8 onto a substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

10. The patterning process according to claim 9, wherein the substrate to be processed has a structure or a step with a height of 30 nm or more.

11. A method for forming a resist underlayer film that serves as an organic planarizing film employed in a semiconductor device manufacturing process, the method comprising:
A)
spin-coating a substrate to be processed with the composition for forming a resist underlayer film according to any one of claims 1 to 8; and
heating the substrate coated with the composition for forming a resist underlayer film at a temperature of 100°C or higher and 800°C or lower for 10 to 600 seconds to form a cured film; or
B)
spin-coating a substrate to be processed with the composition for forming a resist underlayer film according to any one of claims 1 to 8; and
heating the substrate coated with the composition for forming a resist underlayer film under an atmosphere with an oxygen concentration of 1% or more and 21% or less to form a cured film; or
C)
spin-coating a substrate to be processed with the composition for forming a resist underlayer film according to any one of claims 1 to 8; and
heating the substrate coated with the composition for forming a resist underlayer film under an atmosphere with an oxygen concentration of less than 1% to form a cured film.

12. The method for forming a resist underlayer film according to claim 11, wherein the substrate to be processed has a structure or a step with a height of 30 nm or more.

## Patentansprüche

1. Zusammensetzung zur Bildung eines Resist-Untergrundfilms, umfassend: (A) ein Polymer mit einer Struktur, dargestellt durch die folgende allgemeine Formel (1A); (B) ein Vernetzungsmittel, dargestellt durch die folgende allgemeine Formel (B-1); und (C) ein organisches Lösungsmittel, wobei das Polymer (A) keine Hydroxylgruppen enthält und das Vernetzungsmittel (B) in einer Menge von 5 bis 50 Masseteilen, bezogen auf 100 Masseteile des Polymers (A), enthalten ist, 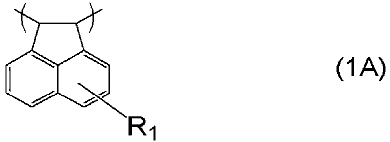
wobei R₁ ein Wasserstoffatom, ein Halogenatom oder eine lineare, verzweigte oder cyclische Kohlenwasserstoffgruppe mit 1 bis 20 Kohlenstoffatomen darstellt, 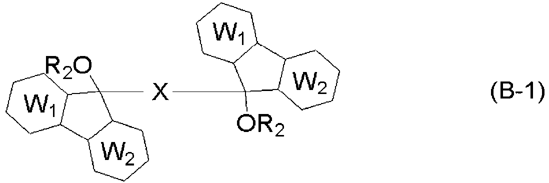
wobei W₁ und W₂ jeweils unabhängig voneinander einen Benzolring oder einen Naphthalinring optional mit einem Substituenten darstellen, jedes R₂ unabhängig voneinander ein Wasserstoffatom oder eine einwertige organische Gruppe mit 1 bis 20 Kohlenstoffatomen darstellt und X eine Gruppe darstellt, dargestellt durch eine der folgenden Formeln (2), 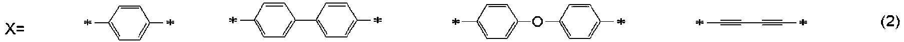
wobei "*" eine Bindungsstelle darstellt.

2. Zusammensetzung zur Bildung eines Resist-Untergrundfilms gemäß Anspruch 1, ferner umfassend ein Polymer mit Teilstrukturen, die durch die folgenden allgemeinen Formeln (1B) dargestellt werden, 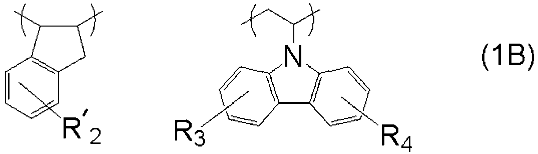 wobei R'₂, R₃ und R₄ jeweils unabhängig voneinander ein Wasserstoffatom, ein Halogenatom oder eine lineare, verzweigte oder cyclische Kohlenwasserstoffgruppe mit 1 bis 20 Kohlenstoffatomen darstellen.

3. Zusammensetzung zur Bildung eines Resist-Untergrundfilms gemäß Anspruch 1 oder 2, wobei das Polymer (A) Strukturen aufweist, die durch die folgenden allgemeinen Formeln (1C) dargestellt werden, 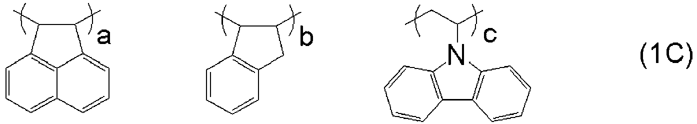 wobei "a", "b" und "c" die Bedingungen a+b+c = 1, 0,5 ≤ a ≤ 0,9 und 0,1 ≤ b+c ≤ 0,5 erfüllen.

4. Zusammensetzung zur Bildung eines Resist-Untergrundfilms gemäß einem der Ansprüche 1 bis 3, wobei das Polymer (A) ein gewichtsmittleres Molekulargewicht Mw von 500 bis 5.000 aufweist, gemessen durch Gelpermeationschromatographie in Bezug auf Polystyrol.

5. Zusammensetzung zur Bildung eines Resist-Untergrundfilms gemäß einem der Ansprüche 1 bis 4, wobei das Vernetzungsmittel (B) die Bedingung 1,00 ≤ Mw/Mn ≤ 1,25 erfüllt, wobei Mw das gewichtsmittlere Molekulargewicht und Mn das zahlenmittlere Molekulargewicht ist, gemessen durch Gelpermeationschromatographie in Bezug auf Polystyrol.

6. Zusammensetzung zur Bildung eines Resist-Untergrundfilms gemäß einem der Ansprüche 1 bis 5, umfassend (D) einen Fließbeschleuniger mit einer Gewichtsreduktionsrate von weniger als 30 % bei 30 °C bis 190 °C und einer Gewichtsreduktionsrate von 98 % oder mehr bei 30 °C bis 350 °C.

7. Zusammensetzung zur Bildung eines Resist-Untergrundfilms gemäß Anspruch 6, wobei der Fließbeschleuniger (D) eine oder mehrere Verbindungen enthält, ausgewählt aus den folgenden allgemeinen Formeln (i) bis (iii), 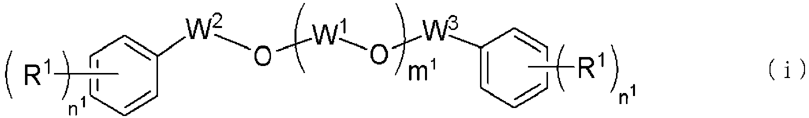
wobei jedes R¹ unabhängig voneinander ein Wasserstoffatom, eine Hydroxygruppe oder eine optional substituierte organische Gruppe mit 1 bis 10 Kohlenstoffatomen darstellt; W¹ eine Phenylengruppe oder eine zweiwertige Gruppe darstellt, die durch die folgende allgemeine Formel (i-1) dargestellt wird; W² und W³ jeweils unabhängig voneinander eine Einfachbindung oder eine zweiwertige Gruppe darstellen, die durch eine der folgenden Formeln (i-2) dargestellt wird; "m¹" eine ganze Zahl von 1 bis 10 darstellt; und "n¹" eine ganze Zahl von 0 bis 5 darstellt, 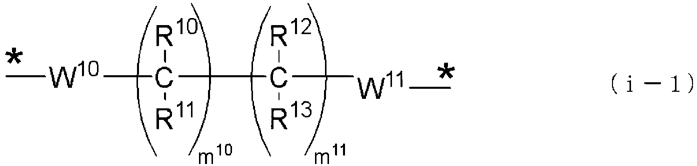
wobei "*" eine Bindungsstelle darstellt; R¹⁰, R¹¹, R¹², und R¹³ jeweils unabhängig voneinander ein Wasserstoffatom, eine Hydroxygruppe oder eine organische Gruppe mit 1 bis 10 Kohlenstoffatomen darstellen; W¹⁰ und W¹¹ jeweils unabhängig voneinander eine Einfachbindung oder eine Carbonylgruppe darstellen; und "m¹⁰" und "m¹¹" eine ganze Zahl von 0 bis 10 darstellen, mit der Maßgabe, dass m¹⁰+m¹¹ ≥ 1 ist, 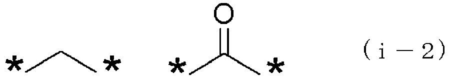
wobei "*" eine Bindungsstelle darstellt, 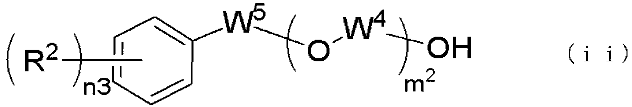
wobei jedes R² unabhängig voneinander ein Wasserstoffatom oder eine optional substituierte organische Gruppe mit 1 bis 10 Kohlenstoffatomen darstellt; W⁴ eine zweiwertige Gruppe darstellt, die durch die folgende allgemeine Formel (ii-1) dargestellt wird; W⁵ eine Einfachbindung oder eine zweiwertige Gruppe darstellt, die durch eine der folgenden Formeln (ii-2) dargestellt wird; "m²" eine ganze Zahl von 2 bis 10 darstellt; und "n³" eine ganze Zahl von 0 bis 5 darstellt, 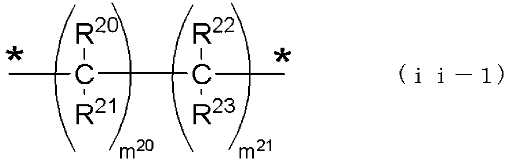
wobei "*" eine Bindungsstelle darstellt; R²⁰, R²¹, R²² und R²³ jeweils unabhängig voneinander ein Wasserstoffatom, eine Hydroxygruppe oder eine organische Gruppe mit 1 bis 10 Kohlenstoffatomen darstellen; und "m²⁰" und "m²¹" eine ganze Zahl von 0 bis 10 darstellen, mit der Maßgabe, dass m²⁰+m²¹ ≥ 1 ist, 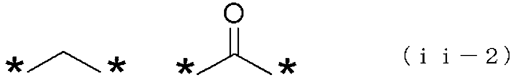
wobei "*" eine Bindungsstelle darstellt, 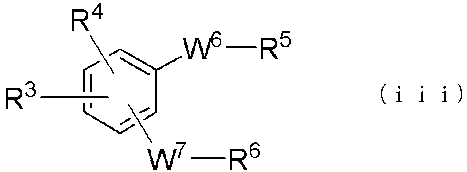
wobei R³ und R⁴ jeweils unabhängig voneinander ein Wasserstoffatom, eine Hydroxygruppe oder eine optional substituierte organische Gruppe mit 1 bis 10 Kohlenstoffatomen darstellen und optional miteinander verbunden sind, um eine cyclische Struktur zu bilden; R⁵ und R⁶ jeweils unabhängig voneinander eine organische Gruppe mit 1 bis 10 Kohlenstoffatomen darstellen, wobei R⁵ eine Gruppe enthaltend einen aromatischen Ring oder eine zweiwertige Gruppe ist, die durch die folgende allgemeine Formel (iii-1) dargestellt wird; und W⁶ und W⁷ eine Einfachbindung oder eine zweiwertige Gruppe darstellen, die durch eine der folgenden Formeln (iii-2) dargestellt wird, wobei mindestens eines von W⁶ und W⁷ eine zweiwertige Gruppe ist, die durch eine der folgenden Formeln (iii-2) dargestellt wird, 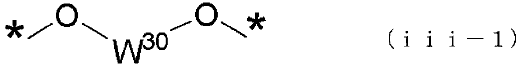
wobei "*" eine Bindungsstelle darstellt; und W³⁰ eine organische Gruppe mit 1 bis 4 Kohlenstoffatomen darstellt, 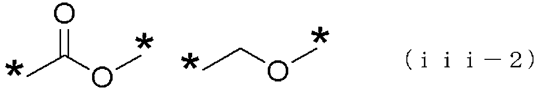
wobei "*" eine Bindungsstelle darstellt.

8. Zusammensetzung zur Bildung eines Resist-Untergrundfilms gemäß einem der Ansprüche 1 bis 7, ferner umfassend eines oder mehrere der Folgenden: (E) ein Tensid, (F) einen Säuregenerator und (G) einen Weichmacher.

9. Verfahren zum Strukturieren eines zu bearbeitenden Substrats, umfassend die folgenden Schritte:
A)
(I-1) Aufbringen der Zusammensetzung zur Bildung eines Resist-Untergrundfilms gemäß einem der Ansprüche 1 bis 8 auf ein zu bearbeitendes Substrat, gefolgt von Erhitzen, um einen Resist-Untergrundfilm zu bilden;
(I-2) Ausbilden eines Resist-Oberschichtfilms auf dem Resist-Untergrundfilm unter Verwendung eines Fotoresistmaterials;
(I-3) Unterziehen des Resist-Oberschichtfilms einer Strukturbelichtung und anschließendes Entwickeln mit einem Entwickler, um eine Struktur in dem Resist-Oberschichtfilm zu bilden;
(I-4) Übertragen der Struktur auf den Resist-Untergrundfilm durch Trockenätzen unter Verwendung des Resist-Oberschichtfilms mit der gebildeten Struktur als Maske; und
(I-5) Bearbeiten des zu bearbeitenden Substrats unter Verwendung des Resist-Untergrundfilms mit der gebildeten Struktur als Maske, um die Struktur in dem zu bearbeitenden Substrat zu bilden; oder
B)
(II-1) Aufbringen der Zusammensetzung zur Bildung eines Resist-Untergrundfilms gemäß einem der Ansprüche 1 bis 8 auf ein zu bearbeitendes Substrat, gefolgt von Erhitzen, um einen Resist-Untergrundfilms zu bilden;
(II-2) Ausbilden eines Resist-Mittelschichtfilms auf dem Resist-Untergrundfilm;
(II-3) Ausbilden eines Resist-Oberschichtfilms auf dem Resist-Mittelschichtfilm unter Verwendung eines Fotoresistmaterials;
(II-4) Unterziehen des Resist-Oberschichtfilms einer Strukturbelichtung und anschließendes Entwickeln mit einem Entwickler, um eine Struktur in dem Resist-Oberschichtfilm zu bilden;
(II-5) Übertragen der Struktur auf den Resist-Mittelschichtfilm durch Trockenätzen unter Verwendung des Resist-Oberschichtfilms mit der gebildeten Struktur als Maske;
(II-6) Übertragen der Struktur auf den Resist-Untergrundfilm durch Trockenätzen unter Verwendung des Resist-Mittelschichtfilms mit der übertragenen Struktur als Maske; und
(II-7) Bearbeiten des zu bearbeitenden Substrats unter Verwendung des Resist-Untergrundfilms mit der gebildeten Struktur als Maske, um die Struktur in dem zu bearbeitenden Substrat zu bilden; oder
C)
(III-1) Aufbringen der Zusammensetzung zur Bildung eines Resist-Untergrundfilms gemäß einem der Ansprüche 1 bis 8 auf ein zu bearbeitendes Substrat, gefolgt von Erhitzen, um einen Resist-Untergrundfilm zu bilden;
(III-2) Bilden eines anorganischen Hartmasken-Mittelschichtfilms, ausgewählt aus einem Siliziumoxidfilm, einem Siliziumnitridfilm und einem Siliziumoxynitridfilm, auf dem Resist-Untergrundfilm;
(III-3) Ausbilden eines organischen Dünnfilms auf dem anorganischen Hartmasken-Mittelschichtfilm;
(III-4) Ausbilden eines Resist-Oberschichtfilms auf dem organischen Dünnfilm unter Verwendung eines Fotoresistmaterials;
(III-5) Unterziehen des Resist-Oberschichtfilms einer Strukturbelichtung und anschließendes Entwickeln mit einem Entwickler, um eine Struktur in dem Resist-Oberschichtfilm zu bilden;
(III-6) Übertragen der Struktur auf den organischen Dünnfilm und den anorganische Hartmasken-Mittelschichtfilm durch Trockenätzen unter Verwendung des Resist-Oberschichtfilms mit der gebildeten Struktur als Maske;
(III-7) Übertragen der Struktur auf den Resist-Untergrundfilm durch Trockenätzen unter Verwendung des anorganischen Hartmasken-Mittelschichtfilms mit der übertragenen Struktur als Maske; und
(III-8) Bearbeiten des zu bearbeitenden Substrats unter Verwendung des Resist-Untergrundfilms mit der gebildeten Struktur als Maske, um die Struktur in dem zu bearbeitenden Substrat zu bilden.

10. Strukturierungsprozess gemäß Anspruch 9, wobei das zu bearbeitende Substrat eine Struktur oder eine Stufe mit einer Höhe von 30 nm oder mehr aufweist.

11. Verfahren zum Bilden eines Resist-Untergrundfilms, der als organischer Planarisierungsfilm dient, der in einem Halbleiterbauelement-Herstellungsprozess verwendet wird, wobei das Verfahren umfasst:
A)
Schleuderbeschichten eines zu bearbeitenden Substrats mit der Zusammensetzung zur Bildung eines Resist-Untergrundfilms gemäß einem der Ansprüche 1 bis 8; und
Erhitzen des mit der Zusammensetzung zur Bildung eines Resist-Untergrundfilms beschichteten Substrats bei einer Temperatur von 100 °C oder höher und 800 °C oder niedriger für 10 bis 600 Sekunden, um einen ausgehärteten Film zu bilden; oder
B)
Schleuderbeschichten eines zu bearbeitenden Substrats mit der Zusammensetzung zur Bildung eines Resist-Untergrundfilms gemäß einem der Ansprüche 1 bis 8; und
Erhitzen des mit der Zusammensetzung zur Bildung eines Resist-Untergrundfilms beschichteten Substrats unter einer Atmosphäre mit einer Sauerstoffkonzentration von 1 % oder mehr und 21 % oder weniger, um einen ausgehärteten Film zu bilden; oder
C)
Schleuderbeschichten eines zu bearbeitenden Substrats mit der Zusammensetzung zur Bildung eines Resist-Untergrundfilms gemäß einem der Ansprüche 1 bis 8; und
Erhitzen des mit der Zusammensetzung zur Bildung eines Resist-Untergrundfilms beschichteten Substrats unter einer Atmosphäre mit einer Sauerstoffkonzentration von weniger als 1 %, um einen ausgehärteten Film zu bilden.

12. Verfahren zum Bilden eines Resist-Untergrundfilms gemäß Anspruch 11, wobei das zu bearbeitende Substrat eine Struktur oder eine Stufe mit einer Höhe von 30 nm oder mehr aufweist.

## Revendications

1. Composition servant à former un film de sous-couche de résine photosensible, comprenant: (A) un polymère ayant une structure représentée par la formule générale (1A) suivante; (B) un agent de réticulation représenté par la formule générale (B-1) suivante; et (C) un solvant organique, le polymère (A) ne contenant pas de groupes hydroxy et l'agent de réticulation (B) étant contenu à hauteur de 5 à 50 parties en masse pour 100 parties en masse du polymère (A), 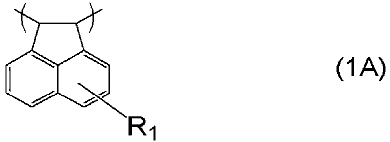
dans laquelle R1 représente un atome d'hydrogène, un atome d'halogène ou un groupe linéaire 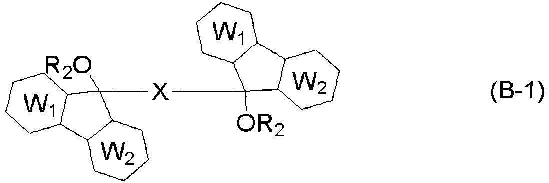
dans laquelle W₁ et W₂ représentent chacun indépendamment un cycle benzénique ou un cycle naphtalénique comportant éventuellement un substituant, chaque R₂ représente indépendamment un atome d'hydrogène ou un groupe organique monovalent comportant 1 à 20 atomes de carbone, et X représente un groupe représenté par l'une des formules (2) suivantes, 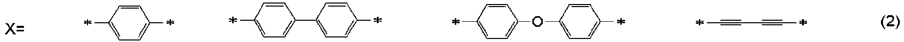
dans lesquelles « * » représente un point d'attache.

2. Composition pour former un film de sous-couche de résine photosensible selon la revendication 1, comprenant en outre un polymère ayant des structures partielles représentées par les formules générales (1B) suivantes, 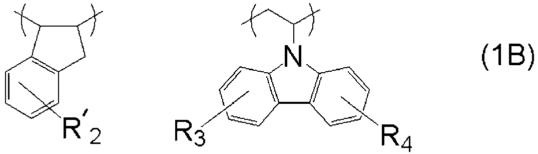 dans laquelle R'₂, R₃, et R₄ représente chacun un atome d'hydrogène, un atome d'halogène ou un groupe hydrocarbone linéaire, ramifié ou cyclique comportant 1 à 20 atomes de carbone.

3. Composition servant à former un film de sous-couche de résine photosensible selon la revendication 1 ou 2, dans laquelle le polymère (A) présente des structures représentées par la formule générale suivante (1C), 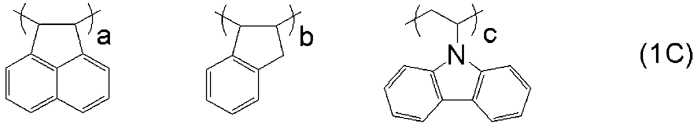 dans laquelle « a », « b» et « c » satisfont a+b+c = 1, 0,5 ≤ a ≤ 0,9 et 0,1 ≤ b+c ≤ 0,5.

4. Composition servant à former un film de sous-couche de résine photosensible selon l'une quelconque des revendications 1 à 3, dans lequel le polymère (A) a un poids moléculaire moyen en poids Mw compris entre 500 et 5 000, mesuré par chromatographie par perméation de gel en termes de polystyrène.

5. Matériau servant à former un film de sous-couche de résine photosensible selon l'une quelconque des revendications 1 à 4, dans lequel l'agent de réticulation (B) satisfait à 1,00 ≤ Mw/Mn ≤ 1,25, Mw est une masse moléculaire moyenne en poids et Mn une masse moléculaire moyenne en nombre mesurée par chromatographie par perméation de gel en termes de polystyrène.

6. Composition servant à former un film de sous-couche de résine photosensible selon l'une quelconque des revendications 1 à 5, comprenant (D) un accélérateur de fluidité présentant un taux de réduction de poids inférieur à 30 % entre 30°C et 190°C et un taux de réduction de poids supérieur ou égal à 98 % entre 30°C et 350°C.

7. Composition servant à former un film de sous-couche de résine photosensible selon la revendication 6, dans laquelle l'accélérateur de fluidité (D) contient un ou plusieurs composés choisis parmi les formules générales (i) à (iii) suivantes, 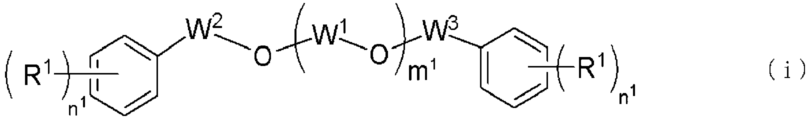
dans laquelle chaque R¹ représente indépendamment un atome d'hydrogène, un groupe hydroxy ou un groupe organique éventuellement substitué ayant 1 à 10 atomes de carbone; R¹ représente un groupe phénylène ou un groupe divalent représenté par la formule générale (i-1) suivante; W² et W³ représentent chacun indépendamment une liaison simple ou un groupe divalent représenté par l'une des formules suivantes (i-2); « m1 » représente un nombre entier de 1 à 10; et «n¹» représente un nombre entier entre 0 et 5, 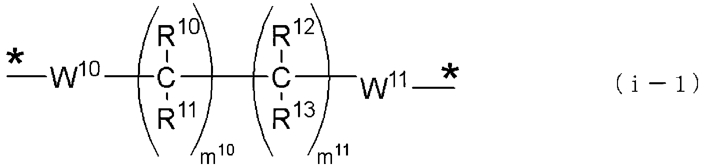
dans laquelle « * » représente un point d'attache; R¹⁰, R¹¹, R¹², et R¹³ représentent chacun indépendamment un atome d'hydrogène, un groupe hydroxy ou un groupe organique ayant 1 à 10 atomes de carbone; W¹⁰ et W¹¹ représentent chacun indépendamment une liaison simple ou un groupe carbonyle; et «m¹⁰» et «m¹¹» représentent un nombre entier entre 0 et 10, à condition que m¹⁰+m¹¹ +≥ 1, 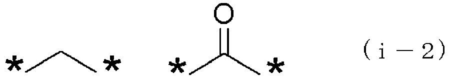
dans laquelle « * » représente un point d'attache, 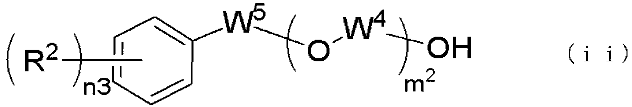
dans laquelle chaque R² représente indépendamment un atome d'hydrogène ou un groupe organique éventuellement substitué ayant 1 à 10 atomes de carbone; W⁴ représente un groupe divalent représenté par la formule générale (i-1) suivante; W⁵ représente une liaison simple ou un groupe divalent représenté par l'une des formules suivantes (ii-2); « m² » représente un nombre entier entre 2 et 10; et « n³» représente un nombre entier entre 0 et 5, 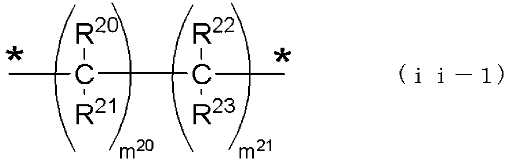
dans laquelle « * » représente un point de fixation; R²⁰, R²¹, R²², et R²³ représentent chacun indépendamment un atome d'hydrogène, un groupe hydroxy ou un groupe organique ayant 1 à 10 atomes de carbone; et « m²⁰ » et « m²¹ » représentent un nombre entier entre 0 et 10, à condition que m²⁰+m²¹ ≥ 1, 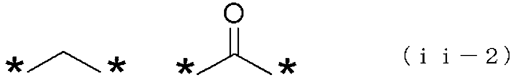
dans laquelle « * » représente un point d'attache, 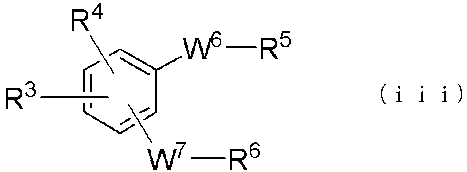
dans laquelle R³ et R⁴ représentent chacun indépendamment un atome d'hydrogène, un groupe hydroxy ou un groupe organique éventuellement substitué ayant 1 à 10 atomes de carbone et sont éventuellement liés l'un à l'autre pour former une structure cyclique; R⁵ et R⁶ représentent chacun indépendamment un groupe organique ayant 1 à 10 atomes de carbone, R⁵ étant un groupe contenant un cycle aromatique ou un groupe divalent représenté par la formule générale (iii-1) suivante; et W⁶ et W⁷ représentent une liaison simple ou un groupe divalent représenté par l'une des formules (iii-2) suivantes, au moins l'un parmi W⁶ et W⁷ étant un groupe divalent représenté par l'une des formules (iii-2) suivantes, 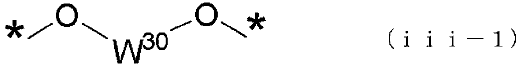
dans laquelle « * » représente un point d'attache; et W³⁰ représente un groupe organique ayant 1 à 4 atomes de carbone, 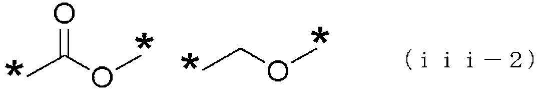
dans laquelle « * » représente un point d'attache.

8. Composition servant à former un film de sous-couche de résine photosensible selon l'une quelconque des revendications 1 à 7, comprenant en outre un ou plusieurs parmi (E) un tensioactif, (F) un générateur d'acide, et (G) un plastifiant.

9. Procédé de formation de motif permettant de former un motif dans un substrat à traiter, comprenant les étapes consistant à:
A)
(I-1) appliquer la composition servant à former un film de sous-couche de résine photosensible selon l'une quelconque des revendications 1 à 8 sur un substrat à traiter, puis chauffer pour former un film de sous-couche de résine photosensible;
(I-2) former un film de couche supérieure de résine photosensible sur le film de sous-couche de résine photosensible en faisant appel à un matériau de résine photosensible;
(I-3) soumettre le film de couche supérieure de résine photosensible à une exposition de motif, puis à un développement en faisant appel à un révélateur pour former un motif dans le film de couche supérieure de résine photosensible;
(I-4) transférer le motif sur le film de sous-couche de résine photosensible par gravure à sec tout en utilisant le film de couche supérieure de résine photosensible ayant le motif formé comme masque; et
(I-5) traiter le substrat à traiter tout en utilisant le film de sous-couche de résine photosensible ayant le motif formé comme masque pour former le motif dans le substrat à traiter; ou
B)
(II-1) appliquer la composition servant à former un film de sous-couche de résine photosensible selon l'une quelconque des revendications 1 à 8 sur un substrat à traiter, puis chauffer pour former un film de sous-couche de résine photosensible;
(II-2) former un film de couche intermédiaire de résine photosensible sur le film de sous-couche de résine photosensible;
(II-3) former un film de couche supérieure de résine photosensible sur le film de couche intermédiaire de résine photosensible à l'aide d'un matériau de résine photosensible;
(II-4) soumettre le film de couche supérieure de résine photosensible à une exposition de motif, puis à un développement à l'aide d'un révélateur pour former un motif dans le film de couche supérieure de résine photosensible;
(II-5) transférer le motif sur le film de couche intermédiaire de résine photosensible par gravure à sec tout en utilisant le film de couche supérieure de résine photosensible ayant le motif formé comme masque;
(II-6) transférer le motif sur le film de sous-couche de résine photosensible par gravure à sec tout en utilisant le film de couche intermédiaire de résine photosensible comportant le motif transféré comme masque; et
(II-7) traiter le substrat à traiter tout en utilisant le film de sous-couche de résine photosensible comportant le motif formé comme masque afin de former le motif dans le substrat à traiter; ou
C)
(III-1) appliquer la composition servant à former un film de sous-couche de résine photosensible selon l'une quelconque des revendications 1 à 8 sur un substrat à traiter, puis chauffer pour former un film de sous-couche de résine photosensible;
(III-2) former un film de couche intermédiaire de masque dur inorganique choisi parmi un film d'oxyde de silicium, un film de nitrure de silicium et un film d'oxynitrure de silicium sur le film de sous-couche de résine photosensible;
(III-3) former un film mince organique sur le film de couche intermédiaire de masque dur inorganique;
(III-4) former un film de couche supérieure de résine photosensible sur le film mince organique à l'aide d'un matériau de résine photosensible ;
(III-5) soumettre le film de couche supérieure de résine photosensible à une exposition de motif, puis à un développement à l'aide d'un révélateur pour former un motif dans le film de couche supérieure de résine photosensible;
(III-6) transférer le motif sur le film mince organique et le film de couche intermédiaire de masque dur inorganique par gravure à sec tout en utilisant le film de couche supérieure de résine photosensible ayant le motif formé comme masque;
(III-7) transférer le motif sur le film de sous-couche de résine photosensible par gravure à sec tout en utilisant le film de couche intermédiaire de masque dur inorganique comportant le motif transféré comme masque; et
(III-8) traiter le substrat à traiter tout en utilisant le film de sous-couche de résine photosensible comportant le motif formé comme masque afin de former le motif dans le substrat à traiter.

10. Procédé de formation de motif selon la revendication 9, dans lequel le substrat à traiter présente une structure ou une étape d'une hauteur de 30 nm ou plus.

11. Procédé de formation d'un film de sous-couche de résine photosensible qui sert de film de planarisation organique utilisé dans un processus de fabrication de dispositif semi-conducteur, le procédé comprenant:
A)
l'enduction centrifuge d'un substrat à traiter avec la composition servant à former un film de sous-couche de résine photosensible selon l'une quelconque des revendications 1 à 8; et
le chauffage du substrat revêtu de la composition servant à former un film de sous-couche de résine photosensible à une température allant de 100°C ou plus à 800°C ou moins dans une plage de 10 à 600 secondes pour former un film durci; ou
B)
appliquer par centrifugation sur un substrat à traiter la composition pour former un film de sous-couche de résine photosensible selon l'une quelconque des revendications 1 à 8; et
chauffer le substrat recouvert de la composition pour former un film de sous-couche de résine photosensible dans une atmosphère ayant une concentration en oxygène comprise entre 1 % et 21 % afin de former un film durci ; ou
C)
enduire par centrifugation un substrat à traiter de la composition pour former un film de sous-couche de résine photosensible selon l'une quelconque des revendications 1 à 8; et
chauffer le substrat recouvert de la composition servant à former un film de sous-couche de résine photosensible dans une atmosphère dont la concentration en oxygène est inférieure à 1 % afin de former un film durci.

12. Procédé de formation d'un film de sous-couche de résine photosensible selon la revendication 11, dans lequel le substrat à traiter présente une structure ou une étape d'une hauteur de 30 nm ou plus.
